# FASCICULE DE BREVET EUROPEEN

(11) **EP 3 080 783 B1**
(45) Date de publication et mention de la délivrance du brevet: **01.07.2026**
(21) Numéro de dépôt: 14869194.2
(22) Date de dépôt: 12.12.2014
(51) Int. Cl.: G06T 19/20

(54) **METHODE ET SYSTEME DE COMPARAISON DE MODELES 3D**
VERFAHREN UND SYSTEM ZUM VERGLEICHEN VON 3D-MODELLEN
METHOD AND SYSTEM FOR COMPARING 3D MODELS

(30) Priorité: 15.12.2013 US 201361916279 P
(43) Date de publication de la demande: 19.10.2016
(73) Titulaire: 7893159 Canada Inc., Montreal, Québec H3C 2M7 (CA)
(72) Inventeur: MARANZANA, Roland, Montreal, Québec H8R 2N9 (CA); MSAÂF, Omar, Montreal, Québec H3J 1T6 (CA)
(74) Mandataire: Ipsilon
(86) Numéro de dépôt international: PCT/IB2014/066870
(87) Numéro de publication internationale: WO 2015/087308

(56) Documents cités:
- EP-A1- 2 284 770
- US-A1- 2005 276 443
- US-A1- 2013 080 045
- US-B1- 6 625 607
- KOLONIAS I ET AL: "Fast Content-Based Search of VRML Models Based on Shape Descriptors", IEEE TRANSACTIONS ON MULTIMEDIA, IEEE SERVICE CENTER, PISCATAWAY, NJ, US, vol. 7, no. 1, 1 February 2005 (2005-02-01), pages 114 - 126, XP011125468, ISSN: 1520-9210, DOI: 10.1109/TMM.2004.840605
- KOLONIAS ET AL.: "Fast content-based search of VRML models based on shape descriptors", IEEE TRANSACTIONS ON MULTIMEDIA, vol. 7, no. 1, February 2005 (2005-02-01), pages 114 - 126, XP011125468, ISSN: 1520-9210

## Description

### Domaine de l'invention

Cette demande de brevet a trait au domaine des modèles 3D, par exemple les représentations numériques dans un espace de dimension 3, et plus précisément au domaine de la comparaison de modèles 3D, notamment par le biais de descripteurs, pour les fins d'une recherche, d'un classement et/ou d'une analyse comparative des parties.

### Historique de l'invention

Les représentations numériques en 3 dimensions d'objets sont d'emploi courant dans les mondes de l'ingénierie, du médicale, du jeu vidéo, du cinéma, et même dans les applications de masse (mentionnons SketchUp^{™} par Google, aujourd'hui Trimble^{™}). Cet usage est possible notamment grâce aux logiciels de création et d'édition 3D dont les systèmes de CAO (conception assistée par ordinateur), à l'ingénierie inverse et à d'autres techniques de reconstruction 3D, mais grâce également aux équipements de numérisation 3D. Tous ces moyens génèrent des modèles numériques de dimension 3. D'aucuns constituent des modèles 3D qui décrivent les limites entre les objets et leur environnement et que l'on appelle des représentations par les frontières (en anglais boundary représentation ou B-rep, que l'on rencontre par exemple dans la norme STEP ou dans des modeleurs géométriques comme Parasolid^{™} ou Acis^{™}).D' autres y vont d'une facettisation ou d'une tessellation (comme les formats STL ou VRML, par exemple). Ces modèles peuvent inclure des informations autres que purement géométriques.

Les types de modèles 3D susmentionnés sont d'ailleurs très répandus dans les entreprises et dans de nombreux secteurs de la vie courante, et leur nombre déjà élevé augmente rapidement. Par conséquent, un problème combiné se pose, soit (i) de répertorier les modèles 3D, (ii) de retrouver des objets numériques similaires, (iii) de les comparer afin d'en identifier les différences ou les parties identiques, et enfin (iv) d'afficher les résultats pertinents pour assurer une exploitation simple et efficace en fonction de critères définis.

Il existe aujourd'hui deux catégories distinctes de systèmes pour d'une part comparer un modèle 3D de référence à un second modèle 3D pour déterminer les différences entre eux et d'autres part rechercher des modèles 3D qui ressemblent à un modèle 3D donné en référence.

### Les systèmes ou outils de comparaisons de modèles 3D

Plusieurs applications informatiques, dont les systèmes de CAO, proposent des méthodes pour comparer entre eux de manière précise deux modèles 3D ou encore un modèle 3D avec un nuage de points ou un modèle 3D reconstruit à partir d'un objet réel. Dans cette approche, deux modèles 3D sont d'abord sélectionnés. On peut choisir parmi plusieurs différentes méthodes pour comparer ces deux modèles. On peut faire appel à la comparaison des structures topologiques et géométriques avec des approches de types graphes (Graph mapping, comme par exemple WO 2007/098929 A1), ou encore faire appel à une méthode basée sur des points (comme par exemple US 7,149,677 H2, ou par la méthode des moindres carrés comme dans le produit d'Innovmetric^{™} ou US 8,072,450 B2). Certaines méthodes exigent que les deux modèles soient dans le même référentiel, dans la même application informatique (même système CAO, par exemple), et utilisent la même représentation géométrique. Les méthodes fondées sur une comparaison aux niveaux géométriques et topologiques exigent impérativement que les deux modèles 3D comparés respectent ces conditions. Tout dépendamment de la méthode de comparaison utilisée, le marquage des modèles 3D distingue les parties identiques et les parties différentes des deux modèles 3D en leur associant par exemple un état (identiques, modifiées, uniques) ou encore en quantifiant les différences entre les deux modèles 3D (une distance entre des points des modèles A et B respectivement, par exemple). Le résultat de la comparaison des deux modèles 3D est ensuite affiché, soit (i) en superposant les deux modèles 3D, (ii) en appliquant une gradation de couleur pour mettre en évidence la différence entre les modèles A et B ou des champs de vecteurs, ou encore (iii) un code de couleur en fonction de l'état défini au module précédent. Cette comparaison indique les parties du modèle 3D (les faces) identiques les parties uniques (faces non appariées) ou modifiées (faces appariées présentant une différence) et éventuellement les parties ajoutées sur un modèle par rapport à l'autre (d'où l'affichage symétrique pour voir ce qui existe sur A par rapport à B et ce qui existe sur B par rapport à A). Bien que tous ces systèmes soient différents, ils se rejoignent tous sur un point : lorsqu'ils comparent le modèle 3D de référence avec le modèle 3D cible, ils choisissent un référentiel unique ou un « best fit » unique duquel ils compareront les modèles 3D complets pour montrer les différences. L'application de Géométrie Ltd inclue dans SolidWorks^{™} est un exemple typique et représentatif de cette catégorie.

### Les systèmes ou outils de recherche de modèles 3D

Une deuxième catégorie d'applications propose de rechercher des modèles 3D en comparant un modèle 3D de référence avec un ensemble de modèles 3D dans le but d'ordonner les modèles 3D en fonction de leur ressemblance avec le modèle 3D de référence. Cette ressemblance est habituellement exprimée par une valeur quantitative utilisée pour ordonner les modèles 3D. Diverses méthodes sont proposées pour déterminer cette ressemblance. Dans un premier temps, chaque modèle 3D est analysé en vue de produire une représentation plus efficace pour réaliser les comparaisons par la suite. En l'espèce, cette représentation est souvent désignée sous divers termes, notamment descripteur, représentation, et index. Quelle que soit son appellation, cette représentation peut avoir plusieurs formes, tel un graphe (US 2004/0249809 Al), un vecteur de dimension N fixe (US 6,625,607 Bl) ou variable en fonction du modèle 3D, etc.

Le document US 6 625 607 B1 (Gear) propose notamment un premier descripteur comprenant cinq valeurs (volume, aire, trois moments d'inertie) qui caractérisent le modèle 3D dans son ensemble. Il propose un deuxième descripteur pour discriminer les pièces miroirs qui contient six valeurs supplémentaires. Cependant, comme indiqué dans ce document, la solution proposée dans ce document couvre uniquement le processus de la recherche de pièces identiques ou très similaires. La comparaison précise de deux modèles connus de pièces ou d'un modèle de pièce avec des données d'inspection est couvert par un autre processus décrit dans les documents US 5,442,572 et US 5,848,115. Il est en outre admit dans ce document que, bien qu'en ne considérant que onze caractéristiques discriminantes et qu'en étant indépendante de tout référentiel pour décrire une pièce, cette approche ne peut être utilisée pour faire de la comparaison détaillée de modèles 3D.

Le remplacement d'un modèle 3D par un ensemble d'images ou de projections 2D est une approche très courante. Par exemple, le document EP 2 284 770 A1 (Papadakis) décrit un procédé utilisant des projections cylindriques, appelées vues panoramiques de l'enveloppe extérieure de l'objet, et la transformée de Fourier discrète 2D et la transformée d'ondelettes discrète 2D. Ce procédé implique donc une première approximation en déplaçant le modèle 3D d'un espace de dimension 3 avec des nombres réels vers un espace de dimension 2 avec des nombres entiers (images, pixels), puis une seconde approximation en utilisant des transformations de Fourier discrètes pour construire le descripteur.

Le document WO 2013/044484 A1 (Tian) décrit un processus pour déterminer si deux modèles 3D sont similaires pour faire de la compression de données. Ce document propose un descripteur invariant en rotation, translation et échelle utilisant des vecteurs normaux à la surface polygonale de l'objet. Dans cette solution, les vecteurs sont projetés sur une sphère découpée en cellules. Le modèle 3D de l'objet est donc une approximation polygonale de la surface, et le descripteur est construit par échantillonnage. Ensuite, de manière itérative, on détermine si deux modèles 3D sont suffisamment similaires pour continuer le traitement. Au final, ce sont les modèles 3D, et non les descripteurs à base de vecteurs, qui sont comparés directement pour trouver les différences réelles entre les deux modèles 3D. En d'autres termes, ce descripteur ne permet pas de faire une comparaison détaillée des modèles 3D.

Le procédé présenté dans les documents US 2009/040225 (Wang) et JP2012 / 043419 (Wang) est un autre exemple d'un procédé de recherche de similarité de modèles 3D similaires à partir d'un ensemble d'images 2D. La solution décrite propose de définir une approche pour repositionner les modèles 3D dans un système de coordonnées commun, puis de déterminer trois projections orthogonales (Droite / Gauche, Avant / Arrière, Haut / Bas) et enfin de traiter ces images pour définir une similitude entre elles. Réduire un modèle 3D en un ensemble (ici trois) d'images conduit inévitablement à une perte d'information et à une approximation. En aucun cas, les images 2D ne peuvent être utilisées pour effectuer une comparaison détaillée des modèles 3D.

Ces approches utilisant des images 2D sont également critiquées dans l'article de Kolonias intitulé " Fast Content-Based Search of VRML Models Based on Shape Descriptors", et publié dans IEEE Transactions on Multimedia, Vol. 7, No. 1, Feb 2005. Kolonias propose notamment une méthode qui s'adresse spécifiquement à la représentation VRML ou l'enveloppe de la pièce est représentée uniquement par un ensemble de triangles. Kolonias considère que la sensibilité aux petits détails est indésirable et propose donc un descripteur (des polylines et un masque de forme qui se révèle être une discrétisation par des voxels du VRML) qui est censé être insensible aux rotations, translations et facteurs d'échelle et qui est une simplification du modèle de l'objet qui est déjà approximée par le VRML. Évidemment, cette approche n'est pas utilisable pour faire de la comparaison de détail entre des modèles 3D.

Dans tous ces procédés de recherche, les descripteurs utilisés sont indépendants du système de coordonnées, c'est-à-dire qu'ils possèdent la propriété d'invariance de rotation car cette propriété est nécessaire pour récupérer des modèles 3D similaires quelle que soit leur position dans le système de coordonnées, mais tous ces procédés utilisent l'approximation, la simplification et l'échantillonnage pour construire un descripteur avec une taille réduite et qui permet ensuite de calculer efficacement un indice de similarité.

Ces descripteurs sont généralement sauvegardés pour être utilisés au moment où les comparaisons sont effectuées. Un modèle 3D est choisi pour servir de référence. Dans certains cas, le modèle 3D de référence est remplacé par des images, des photographies ou des dessins en deux dimensions [A 3D Model Search Engine, Patrick Min, Ph.D. Dissertation, Princeton University, 2004]. Si nécessaire, son descripteur est calculé. Les descripteurs sont comparés. Ici encore plusieurs méthodes sont décrites dans [Content-based Three-dimensional Engineering Shape Search, K. Lou, S. Prabhakar, K. Ramani, Proceedmgs of the 20th International Conférence on Data Engineering 2004]. Toutes les méthodes proposées dans l'art antérieur pour comparer des descripteurs afin de trouver des modèles 3D similaires ont en commun de déterminer une valeur pour caractériser la similarité entre le descripteur de référence et un descripteur cible. En fonction des résultats de la comparaison, les modèles 3D similaires sont généralement ordonnés en fonction d'une grandeur, que nous appelons indice de similarité ou de ressemblance. Ces résultats sont ensuite affichés sous différentes formes, habituellement des images de petites tailles (icônes, miniatures).

Telle que mentionnée précédemment, de nombreuses approches ont été proposées pour rechercher des modèles 3D par rapport à la forme d'un modèle de référence. Certaines approches visent les formes de type organique, d'autres visent une similarité permissive (ex. retrouver des voitures, des chaises, des verres). En particulier, ces méthodes ne sont pas conçues pour déterminer si deux modèles 3D sont exactement les mêmes, avec des précisions du même ordre de grandeur que les tolérances de fabrication. Des systèmes comme par exemple Geolus^{™} de Siemens ou GeoSearch^{™} de Cadenas sont représentatives de cette catégorie. Ils analysent des modèles 3D approximés par des représentations à facettes planes pour générer leurs descripteurs ou par un échantillonnage de points de la frontière (US20100073365) détériorant donc obligatoirement leur précision. Plusieurs méthodes proposées pour extraire les descripteurs des modèles 3D et pour comparer ces descripteurs entre eux, nécessitent un temps de calcul élevé et sont donc difficilement applicables lorsque le nombre de modèles 3D à traiter est important (plus d'un million de modèles, par exemple) ou pour une recherche interactive.

De plus, ces approches recherchent des modèles 3D qui ressemblent dans leur entièreté au modèle 3D de référence, c'est-à-dire le modèle 3D complet. Les systèmes ou outils de recherche de modèles 3D connus ne possèdent ni les informations ni les technologies pour offrir la capacité de lancer une recherche basée sur la prise en compte des parties de modèles 3D ou qui privilégient des parties de ces modèles 3D.

En résumé, dans l'art antérieur, le processus de comparaison détaillée de deux modèles 3D pour détecter des différences et le processus de recherche de similarité de forme entre les modèles sont traitées comme deux problèmes totalement différents et distincts. En conséquence, deux catégories de processus complètement différentes et distinctes ont été proposées pour les résoudre. En particulier, les processus des systèmes de comparaison de modèles 3D n'exigent pas de descripteur qui est au contraire nécessaire aux systèmes de recherche de similarité. Les descripteurs utilisés par les systèmes de recherche de similarité de forme 3D souffrent de limitations sévères, dues à des approximations, des échantillonnages ou des simplifications qui conduisent à une perte définitive d'informations et ne permettent donc pas d'effectuer une comparaison détaillée des modèles 3D pour identifier les différences. Les algorithmes utilisés par les systèmes de recherche de similarité de forme 3D calculent une valeur de similarité unique globale entre un descripteur de référence et un descripteur cible. Cette valeur ne peut pas être utilisée pour identifier la pluralité habituelle de différences entre les deux modèles 3D. D'autre part, les méthodes utilisées par les systèmes de comparaison de modèles 3D pour identifier les différences entre deux modèles 3D ne définissent pas d'indice de similarité entre ces deux modèles 3D. Enfin, même la présentation des résultats est totalement différente pour les deux catégories de processus. Dans un cas, une sorte de marquage met en évidence les différences entre deux modèles 3D. Dans l'autre cas, plusieurs modèles 3D généralement représentés par des images sont classés, en fonction de leur indice de similarité.

### Résumé de l'invention

Il existe des besoins pour des systèmes qui retrouvent des modèles numériques 3D de sources hétérogènes qui se ressemblent en tout ou en partie, qui déterminent et qualifient les différences par rapport à un modèle 3D de référence considéré dans son ensemble ou en partie, qui affichent les résultats avec toute l'information pertinente sur les différences et les ressemblances, le tout de manière extrêmement précise suivant différents critères et qui soient adaptés pour traiter de très grandes quantités de modèles 3D.

Pour répondre à ces besoins, nous proposons un processus qui dans un premier temps, construit des descripteurs pour repérer (ou indexer) les modèles 3D. Ce descripteur se distingue par sa capacité à capturer des propriétés au niveau d'un modèle 3D complet, de chaque corps solide (au sens habituel de la représentation géométrique et topologique tridimensionnelle) composant éventuellement un modèle 3D et aussi des propriétés au niveau de chaque face (toujours au sens habituel de la représentation géométrique et topologique tridimensionnelle) composant le modèle 3D. Les représentations par les frontières ne garantissent pas l'unicité de représentation d'un modèle 3D, c'est-à-dire que plusieurs représentations par les frontières pourraient correspondre au même objet. Pour obtenir cette propriété essentielle à la comparaison des modèles 3D, nous regroupons les faces qui sont continues G2 (dérivée seconde géométrique) tout le long d'une de leur arête commune et nous scindons le long de la discontinuité les faces construites sur une surface qui ne serait pas continue G2. Tous les traitements subséquents du processus, sauf l'affichage en 3D, sont possibles sur les descripteurs sans avoir à recourir nécessairement aux modèles 3D.

Dans la suite du processus proposé, les caractéristiques des descripteurs sont comparées en fonction de critères sélectionnés par l'opérateur. Cette phase repose sur deux éléments, soit la réconciliation des termes ou caractéristiques des descripteurs ce qui correspond à un appairage des corps solides et des faces des modèles 3D et qui de ce fait peuvent être exprimés dans des référentiels différents, des systèmes CAO différents, des représentations géométriques et topologiques différentes et qui autorise la prise en compte de partie seulement des modèles 3D pour le traitement, et la qualification plus rigoureuse des différences au niveau de partie de modèles 3D, des corps solides et des faces, par rapport aux méthodes actuelles que se limitent à identique, modifiée ou nouvelle. Nous introduisons jusqu'à neuf qualités (identique, intrinsèquement identique, type géométrique identique, topologie différente, etc.) et une partie de modèle 3D, un corps solide ou une face peut éventuellement portée plusieurs qualités simultanément. Le marquage pour l'affichage s'appuie sur ces propriétés (par exemple une couleur associée à une combinaison de qualités) et les critères de la requête de l'opérateur. Une fonction basée sur les différences détermine l'indice de ressemblance (ou de similarité) qui ordonne les modèles 3D.

Comme les objets numériques manipulés sont des modèles 3D, nous proposons une nouvelle manière de communiquer les résultats sous la forme d'une structure 3D dans un espace 3D unique. L'un des axes représente l'indice de ressemblance, les couleurs des faces sont utilisées pour marquer les types de différence et les deux axes restant sont par exemple utilisés pour représenter d'autres grandeurs ou propriétés comme par exemple, des coûts, des dates, des fournisseurs, des configurations, des versions, etc.

Ce processus sert par exemple, (i) à repérer des modèles 3D identiques à un modèle 3D de référence avec une précision comparable à celle de leur fabrication (repérage de doublons ou clones géométriques); (ii) à repérer une pièce (un corps solide) identique ou similaire dans un système mécanique (un modèle 3D); (iii) à repérer un composant (ensemble de corps solides) identiques ou similaires dans un système ou plusieurs systèmes (des modèles 3D); (iiii) à repérer des modèles 3D semblables dans de larges banques de modèles 3D éventuellement distribués; etc.

Grâce aux descripteurs qui capturent des propriétés avec une granularité très fine (ensemble de paramètres ou caractéristiques au niveau de chaque face) et aux capacités du comparateur, notamment le principe de réconciliation et la qualification des faces, le système fonctionne également au niveau du repérage de caractéristiques de formes (form features), c'est-à-dire des parties des modèles 3D comme par exemple pour repérer (i) un ensemble de perçages débouchants de diamètre et d'entre-axes donnés (ensemble de faces disjointes et leurs paramètres) dans divers modèles 3D; (ii) une rainure de clavette (ensemble de faces adjacentes et paramètres intrinsèques); (iii) à repérer une face ou un ensemble de faces identiques ou similaires dans un ou plusieurs modèles 3D; etc.

Chaque partie, soit (i) la méthode de recherche de modèle 3D semblables basée sur les descripteurs volumiques et de frontières, (ii) la réconciliation des termes ou caractéristiques des descripteurs autorisant au besoin le multi repositionnement et le repérage de parties de modèle 3D, (iii) le principe de qualification des différences et (iiii) l'affichage de résultats combinant similarités et différences entre plusieurs modèles 3D dans un espace unique de dimension 3, sont des inventions.

Selon un premier aspect de l'invention, on propose un procédé de comparaison des modèles 3D aux fins d'une recherche, d'un classement et/ou d'une analyse comparative des représentations par les frontières des modèles 3D. Selon ce procédé, on fournit un descripteur à chacun d'une pluralité de modèles 3D, les descripteurs comprenant des caractéristiques géométriques des modèles 3D qui sont invariables en fonction du repère de modélisation et des caractéristiques géométriques des modèles 3D qui dépendent du repère. On utilise au besoin des caractéristiques qui sont invariables en fonction du repère pour apparier les parties d'un premier modèle 3D et les parties d'au moins un autre modèle 3D. On utilise des caractéristiques qui dépendent du repère pour au moins les parties dont l'appariement est réussi pour déterminer un groupe de transformations associant les parties entre le premier modèle 3D et les parties d'au moins un autre modèle 3D. On détermine au moins un groupe de transformations identiques, où les ressemblances et les différences entre modèles 3D sont identifiées, au moins en partie, par ledit groupe de transformations identiques (identique s'entend à une tolérance près).

Les caractéristiques géométriques des parties de modèle 3D qui sont invariables en fonction du repère de modèle 3D peuvent comprendre l'aire, les valeurs propres des moments d'inertie et/ou le périmètre des faces planes de modèle 3D, et des caractéristiques géométriques des parties de modèle 3D qui dépendent du repère de modélisation peuvent comprendre le centre de gravité et/ou les axes des moments d'inertie des faces planes.

L'étape de déterminer au moins un groupe de transformations identiques peut comprendre déterminer au moins deux groupes de transformations identiques afin de permettre la comparaison des modèles 3D similaires mais où au moins une partie des modèles 3D est dans une position et/ou orientation différente.

Selon un deuxième aspect de l'invention, on propose un procédé de comparaison de modèles 3D aux fins d'une recherche, d'un classement, et/ou d'une analyse comparative des représentations par les frontières des modèles 3D. Selon ce procédé, on fournit un descripteur à chacun d'une pluralité de modèles 3D, les descripteurs comprenant des caractéristiques géométriques des modèles 3D qui sont invariables en fonction du repère de modélisation et des caractéristiques géométriques des modèles 3D qui dépendent du repère. On utilise des caractéristiques qui sont invariables en fonction du repère pour apparier les faces d'un premier modèle 3D et d'au moins un autre modèle 3D. On stocke les données obtenues dans le processus d'appariement entre les caractéristiques des descripteurs d'au moins deux modèles 3D. Pour les parties de modèles 3D dont l'appariement est réussi, on détermine un groupe de transformation recalant les parties de modèles 3D dans un même repère. On affiche au moins deux modèles 3D dont les parties de modèles 3D sont marquées en fonction des types de différences. Une partie de modèle 3D peut signifier entre autre une face.

Selon un troisième aspect de l'invention, on propose un procédé de comparaison de modèles 3D aux fins d'une recherche, d'un classement, et/ou d'une analyse comparative des représentations par les frontières des modèles 3D. Selon ce procédé, on fournit un descripteur à chacun d'une pluralité de modèles 3D, les descripteurs comprenant des caractéristiques géométriques des modèles 3D qui sont invariables en fonction du repère de modélisation et des caractéristiques géométriques des modèles qui dépendent du repère. On utilise des caractéristiques qui sont invariables en fonction du repère pour apparier les faces d'un premier modèle 3D et d'au moins un autre modèle 3D. On stocke la première collecte de données afférente à l'appariement pour au moins certains modèles 3D. On fournit un premier résultat de recherche, de classement, et/ou de comparaison des représentations par les frontières des modèles 3D en utilisant au moins en partie les données initiales relatives à l'appariement. On continue d'utiliser des caractéristiques qui sont invariables en fonction du repère pour apparier les faces entre le premier modèle 3D et dudit au moins un autre modèle 3D pour bâtir sur ces données initiales relatives à l'appariement. Et, on fournit un deuxième résultat de recherche, de classement, et/ou d'une comparaison des représentations par les frontières en utilisant au moins en partie les données raffinées relatives à l'appariement.

Les caractéristiques géométriques des éléments de modèle 3D qui sont invariables en fonction du repère de modélisation peuvent comprendre l'aire, les valeurs propres des moments d'inertie, le périmètre des faces planes et/ou son type (plan, cylindre par exemple), et des caractéristiques géométriques des éléments de modèle 3D qui dépendent du repère de modélisation peuvent comprendre le centre de gravité et/ou les axes des moments d'inertie des faces planes.

Selon un quatrième aspect de l'invention, on propose un procédé de comparaison des modèles 3D aux fins d'une recherche, d'un classement et/ou d'une analyse comparative des représentations par les frontières des modèles 3D. Selon ce procédé, on fournit un descripteur à chacun d'une pluralité de modèles 3D, les descripteurs comprenant des caractéristiques des modèles 3D. On attribue une importance accrue ou réduite à l'une ou plusieurs caractéristiques dans un premier modèle 3D. On génère une valeur d'appariement entre un premier modèle 3D et au moins un autre modèle 3D grâce aux caractéristiques et, lorsqu'il y a lieu, l'importance attribuée à l'une ou plusieurs de ces caractéristiques du premier modèle 3D.

Selon un cinquième aspect de l'invention, on propose un procédé de comparaison des modèles 3D aux fins d'une recherche, d'un classement et/ou d'une analyse comparative des représentations par les frontières des modèles 3D. Selon ce procédé, on fournit un descripteur à chacun d'une pluralité de modèles 3D. On génère une valeur d'appariement entre un premier modèle 3D et nombre d'autres modèles 3D en utilisant leurs descripteurs respectifs. Et, on génère un affichage de nombre de modèles 3D disposés spatialement en regroupements, où les regroupements sont chacun définis en fonction de caractéristiques de descripteur commune. Les regroupements peuvent être en fonction d'une requête de recherche ou de l'importance accordée à l'une ou des caractéristiques des descripteurs, c'est-à-dire une pondération des descripteurs.

Selon un sixième aspect de l'invention, on propose un procédé de comparaison des modèles 3D aux fins d'une recherche, d'un classement et/ou d'une analyse comparative des représentations par les frontières des modèles 3D. Selon ce procédé, on fournit un descripteur à chacun d'une pluralité de modèles 3D en tenant compte des faces continues géométriquement d'ordre 2 communément dites « continuité G2 », de préférence en les unifiant et en découpant les faces dont les surfaces ne seraient pas continues géométriquement d'ordre 2 (surface G2).

Selon un septième aspect de l'invention, on propose un procédé de comparaison des modèles 3D aux fins d'une recherche, d'un classement et/ou d'une analyse comparative des représentations par les frontières des modèles 3D. Selon ce procédé, on sélectionne au moins une partie sur chacun d'au moins deux modèles 3D. On identifie les parties respectivement identiques et on qualifie les parties différentes par rapport au type de différences. On affiche au moins un des modèles 3D en marquant selon la qualification les parties identiques et différentes.

Selon certaines réalisations, un système de recherche de modèles 3D servant à repérer des modèles 3D parmi une collection de modèles 3D correspondant à un modèle 3D de requête de recherche par l'entremise de descripteurs des modèles 3D comprend un sélecteur de caractéristiques servant à sélectionner au moins une caractéristique ou une partie du modèle 3D de requête de recherche à laquelle on attribue une pondération différente pour les fins de la recherche, et un comparateur de modèles 3D, ledit comparateur configuré pour comparer un descripteur dudit modèle 3D de requête de recherche aux descripteurs de ladite collection de modèles 3D en tenant compte de ladite pondération dudit aspect caractéristique ou partie dudit modèle 3D de requête de recherche, et de produire une liste des modèles correspondants selon la comparaison.

Le sélecteur de caractéristiques peut attribuer des valeurs de pondération aux paramètres d'un descripteur dudit modèle 3D de requête de recherche. Le système peut comprendre en outre un classeur des résultats de recherche et un générateur d'affichage configuré de telle manière à générer des scènes affichables d'au moins une partie de la liste des modèles 3D correspondants, disposés et organisés selon des critères présélectionnés. Lesdits modèles 3D correspondants peuvent être disposés en fonction d'un indice de similarité calculé à partir des descripteurs. Lesdits critères présélectionnés peuvent inclure un critère qui dépend du descripteur. Le sélecteur de caractéristiques peut être configuré de manière à reconnaitre les aspects caractérisants des descripteurs du classeur des résultats et à sélectionner l'un des aspects caractérisants des descripteurs. Les descripteurs peuvent inclure une composante volumétrique et une face et/ou d'autres éléments de la représentation par les frontières.

Selon certaines réalisations, le procédé de fabrication d'un produit est caractérisé par l'exploitation d'un modèle 3D pour la fabrication d'au moins une pièce du produit, ledit modèle 3D étant directement sélectionné et éventuellement modifié en se servant d'un système de recherche/comparaison de modèles 3D ou du procédé selon l'une ou l'autre des réalisations selon la présente invention.

Les caractéristiques de la présente invention qui sont considérées comme nouvelles et inventives seront décrites avec plus de détails dans les revendications présentées ci-après.

Selon un aspect de l'invention, est décrit un procédé de comparaison de modèles 3D comportant une ou plusieurs faces aux fins d'une recherche, d'un classement, ou/et d'une analyse comparative de modèles 3D, le procédé comprenant notamment l'étape de fournir un descripteur à chacun d'une pluralité de modèles 3D, les descripteurs comprenant des caractéristiques géométriques des modèles 3D comprenant au moins des propriétés liées aux faces. Également compris dans le procédé sont les étapes de comparer au moins une partie des caractéristiques des descripteurs des modèles 3D et d'identifier les ressemblances et les différences entre les modèles 3D, au moins pour une partie des modèles 3D.

Selon un aspect de l'invention, est décrit un procédé de comparaison de modèles 3D comportant une ou plusieurs faces aux fins d'une recherche, d'un classement, ou/et d'une analyse comparative de modèles 3D comprenant notamment l'étape de fournir un descripteur à chacun d'une pluralité de modèles 3D, ce descripteur comprenant des caractéristiques géométriques liées à des regroupements de faces continues G2 (continues à la dérivée seconde). Également comprises dans le procédé sont les étapes de comparer au moins une partie des caractéristiques des descripteurs des faces G2 des modèles 3D et d'identifier les ressemblances et les différences entre les modèles 3D, au moins pour une partie des modèles 3D.

Selon un aspect de l'invention, est décrit un procédé de comparaison de modèles 3D comportant une ou plusieurs faces aux fins d'une recherche, d'un classement, ou/et d'une analyse comparative de modèles 3D, comprenant l'étape de demander à un opérateur de sélectionner des caractéristiques d'un modèle 3D pour les fins de comparaison à d'autres modèles 3D, et l'étape de fournir un descripteur comprend la création d'un descripteur selon les caractéristiques du modèle 3D sélectionnés par l'opérateur.

Selon un aspect de l'invention, est décrit un procédé de comparaison de modèles 3D comportant une ou plusieurs faces aux fins d'une recherche, d'un classement, ou/et d'une analyse comparative de modèles 3D comprenant l'étape de comparer le descripteur d'un modèle 3D aux descripteurs d'un grand nombre de modèles 3D, et après avoir présenté des résultats de recherche selon un premier descripteur de recherche, on modifie ce premier descripteur de recherche afin de faire une recherche plus ciblée et/ou on modifie la méthode de calcul de l'indice de similarité.

Selon un aspect de l'invention, est décrit un procédé de visualisation, dans lequel ont présente les résultats de comparaison de modèles 3D comportant une ou plusieurs faces aux fins d'une recherche, d'un classement, ou/et d'une analyse comparative de modèles 3D, sous la forme d'une vue d'un espace 3D comprenant les modèles 3D indiquant leur différences et/ou leur similarités et ordonnés au besoin suivant leur indice de similarité.

Selon un aspect de l'invention, est décrit un procédé de visualisation, dans lequel on présente les résultats de comparaison de modèles 3D comportant une ou plusieurs faces aux fins d'une recherche, d'un classement, ou/et d'une analyse comparative de modèles 3D, sous la forme d'une vue d'un espace 3D comprenant les modèles 3D indiquant leur différences et/ou leur similarités et ordonnés au besoin suivant leur indice de similarité et ou seulement une partie des similarités ou différences est présentée.

Selon un aspect de l'invention, est décrit un système de traitement de données configuré de manière à réaliser le procédé de comparaison des modèles 3D aux fins d'une recherche, d'un classement ou d'une analyse comparative de modèles 3D selon l'une quelconque des revendications précédentes. L'invention est définie dans les revendications indépendantes.

### Définitions

Dans cette demande de brevet, les termes suivants auront la signification suivante:
modèle 3D

Dans ce texte, nous utilisons l'expression modèle 3D pour désigner une représentation numérique dans un espace de dimension 3 d'un objet. Un modèle 3D décrit les limites entre un ou une pluralité d'objets et leur environnement. Ils sont communément basés sur les représentations par les frontières (en anglais boundary representation ou B-rep) comme dans la norme STEP ou les modeleurs géométriques des systèmes de CAO ou FAO par exemple ou les facettisations (tessellation en anglais) comme dans les formats STL ou VRML, par exemple. La frontière est composée d'une ou plusieurs faces, laquelle est une surface limitée par un ou plusieurs contours. Une face est un modèle 3D, une pluralité de faces jointives ou non est un modèle 3D, un ensemble de faces représentant un sous espace euclidien de dimension 3 fermé appelé généralement corps solide, est un modèle 3D. Un ensemble de faces représentant une pluralité de corps solides est un modèle 3D. Dans cette définition, toute partie d'un modèle 3D est un modèle 3D et toute composition de modèles 3D est un modèle 3D. Des modèles 3D peuvent inclure des informations autres que purement géométriques, telles que les propriétés des matériaux utilisés ou les techniques de fabrication préconisées.

### Descripteur

Représentation d'un modèle 3D adaptée pour un usage spécifique, normalement plus efficace et concise que le modèle 3D lui-même. C'est un ensemble d'informations qui caractérisent un modèle 3D ou une partie de celui-ci. Dans certains cas, le descripteur comprend une liste de caractéristiques de géométrie volumétrique d'un modèle 3D comme par exemple et sans être exhaustif, les dimensions de la boite englobante du modèle 3D, son volume, son aire, ses moments d'inertie principaux, son barycentre, ses axes d'inertie principaux, une liste de corps solides du modèle 3D et pour chacun d'entre eux, lequel forme aussi un modèle 3D, le volume, l'aire totale, les moments d'inertie principaux, le barycentre et les axes principaux d'inertie. Dans certains cas, le descripteur inclut une liste de faces du modèle 3D et pour chacune d'elle, une liste de caractéristiques dont le type de la surface sous-jacente et ses paramètres, les dimensions de la boite englobante, l'aire, le périmètre, les moments d'inertie principaux, le barycentre, les axes principaux d'inertie à titre d'exemple et sans être exhaustif. Les différences et la ressemblance entre des modèles 3D sont obtenues à partir d'un processus appelé comparaison des descripteurs. Un modèle 3D peut aussi être un descripteur. Un modèle 3D peut avoir plusieurs descripteurs différents.

### caractéristiques de forme

Une partie ou une propriété (ou un attribut) d'un descripteur (et donc d'un modèle 3D) présentant un intérêt particulier pour un traitement donné. Un élénietit du descripteur ou toute combinaison d'une pluralité d'éléments du descripteur définit une caractéristique de forme. Par exemple, la valeur du diamètre d'une face cylindrique est une caractéristique de forme élémentaire, la valeur d'un entre-axe de deux perçages est une caractéristique de forme, et une rainure de clavette à bout rond est une caractéristique de forme. À chacun de ces exemples correspond une partie d'un descripteur ou la caractéristique de forme peut être déterminée à partir des descripteurs. Dans sa forme la plus élémentaire, la caractéristique de forme est plus simplement appelée caractéristique. Une caractéristique est dite intrinsèque à un modèle 3D ou à son descripteur si elle ne dépend que du dit modèle 3D ou de son descripteur et peut être déterminée à partir de ce dernier et non du contexte, c'est-à-dire un modèle 3D qui engloberait la caractéristique. Dans le cas contraire, la caractéristique est dite extrinsèque.

### Appariement

Processus de détermination de la correspondance entre des caractéristiques de deux descripteurs. Une partie d'un descripteur pourrait par exemple caractériser un corps solide ou une face. L'appariement consiste à faire correspondre à cette partie de descripteur, une autre partie d'un descripteur (le même ou un autre descripteur) lorsque les deux parties de descripteur partagent des caractéristiques communes (identiques ou compris dans des intervalles de valeurs par exemple). Ce processus permet entre autre d'apparier par l'intermédiaire de leurs descripteurs respectifs, les corps solides ou les faces de modèles 3D sans tenir compte de leur position dans l'espace. Ce processus d'appariement n'impose pas que les modèles 3D soient décrits avec la même représentation géométrique (STEP et Parasolid, par exemple) ni qu'ils soient exprimés dans un référentiel commun.

### Réconciliation

Processus de regroupement de parties de descripteurs en prenant en compte la position relative dans l'espace des caractéristiques de formes associées à ces parties de descripteurs appariées. Le processus consiste à déterminer les groupes de matrices de transformation qui permettent de mettre dans un repère commun des caractéristiques de formes. Ce processus permet entre autre, de reconnaitre des caractéristiques de formes identiques ou similaires entre des modèles 3D. Ainsi au niveau des faces par exemple, l'appariement identifie des faces qui partagent des caractéristiques intrinsèques comme par exemple, les faces sont de type cylindrique, le diamètre est entre 5 et 6 mm, la longueur est de 20mm. Lors de la réconciliation, des paramètres extrinsèques sont prises en compte comme par exemple, la direction de l'axe des faces cylindriques est égale à l'axe Z et les entre-axes sont de 20mm. Ce processus appariement - réconciliation peut être appliqué de manière itérative.

### analyse comparative des descripteurs

Processus qui permet de déterminer et de qualifier les caractéristiques identiques et différentes entre des descripteurs selon la requête spécifiée par l'opérateur. La comparaison est effectuée sur tout le descripteur ou seulement sur des parties du descripteur et une pondération différente spécifiée par l'opérateur peut être attribuée à chaque partie pour mettre l'emphase sur certaines caractéristiques de formes, voire à ne considérer qu'une partie du modèle 3D. L'indice de ressemblance (ou indice de similarité) est déterminé à partir de l'analyse comparative des descripteurs.

### Opérateur

Désigne autant un opérateur humain qu'un autre système informatique, interagissant avec le système, en mode interactif ou hors ligne (batch mode).

### Description des dessins

Les réalisations de l'invention seront mieux comprises par le truchement de dessins, lesquels figurent plus loin et lesquels accompagnent nombre d'exemples apparaissant dans la description détaillée des réalisations de l'invention, parmi lesquelles :
La figure 1 présente un diagramme d'une séquence d'étapes d'un procédé selon une réalisation de l'invention;
La figure 2 présente un schéma-blocs d'un système informatique selon une réalisation configurée pour exécuter au moins le procédé selon la figure 1;
La figure 3 est une vue d'un modèle 3D;
La figure 4 est une vue d'une version simplifiée du modèle 3D de la figure 3;
La figure 5 est une vue du modèle 3D de la figure 4 qui identifie de manière générique les faces des modèles 3D;
La figure 6A est une vue du modèle 3D utilisé comme modèle 3D de référence dans la description de cette réalisation;
La figure 6B est une vue d'un modèle 3D semblable à celui de la figure 6A servant à décrire le processus de comparaison;
La figure 7A est une vue des modèles 3D des figures 6A et 6B suivant une première mise en position;
La figure 7B est une vue des modèles 3D des figures 6A et 6B suivant une deuxième mise en position;
La figure 8 illustre une vue en perspective du modèle 3D de référence et une interface permettant la définition de contraintes par l'opérateur montrant un ensemble de contraintes utilisé pour décrire une réalisation particulière;
La figure 9 est une vue en perspective d'une pluralité de modèles 3D semblables positionnés et marqués selon le résultat de leur comparaison par rapport au modèle 3D de référence et les contraintes définies par l'opérateur;
La figure 10 présente un schéma-blocs d'une version du système informatique de la figure 2 suivant une architecture distribuée.

### Description détaillée de l'incarnation préférée

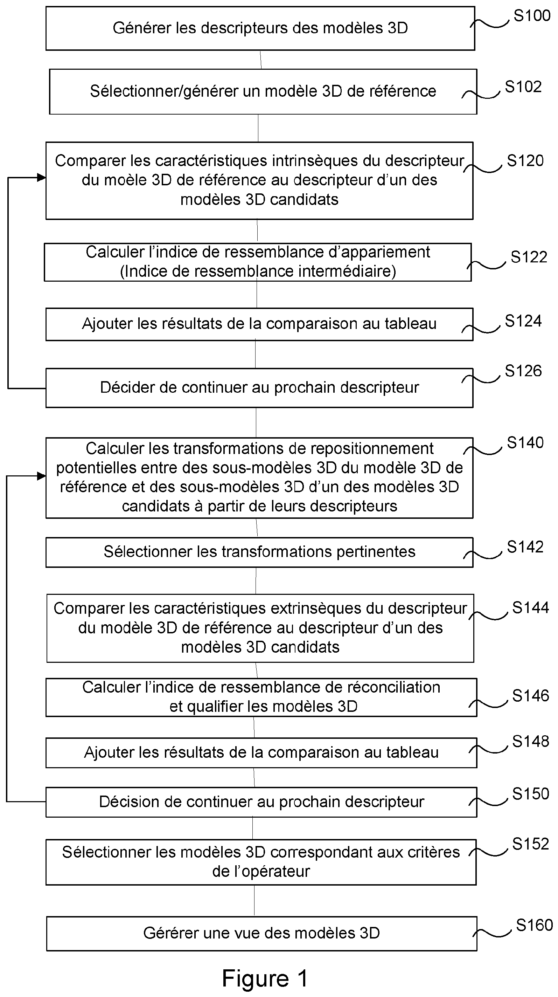

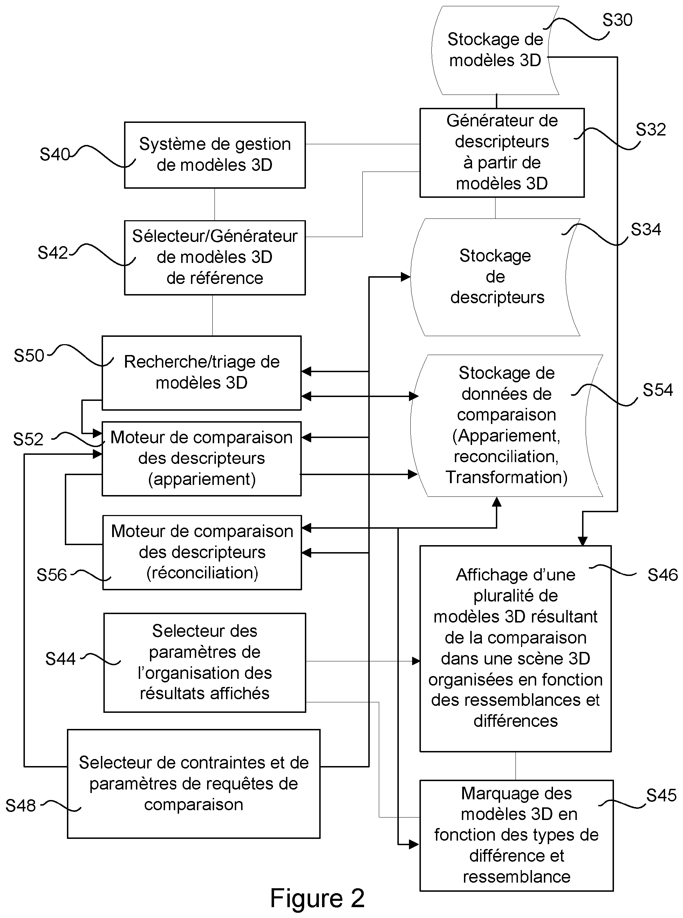

Les réalisations de l'invention sont décrites d'après les Figures 1 et 2, lesquelles montrent la séquence d'étapes à franchir pour déterminer de manière concomitante les ressemblances (ou les similarités) et les différences entre un modèle 3D de référence et un certain nombre de modèles 3D à partir de leurs descripteurs. Le nombre de modèles 3D pris en considération peut varier énormément. Dans la mesure où l'objectif consiste à comparer un modèle 3D de référence à quelques modèles 3D connus, ce nombre peut être petit. En revanche, si l'objectif est de trouver un modèle approprié ou semblable, l'on peut chercher parmi des milliers voire des millions de descripteurs de modèles 3D existants. La Figure 2 illustre en substance un schéma fonctionnel d'un système logiciel lequel peut effectuer les étapes illustrées aux Figures 1 et 2.

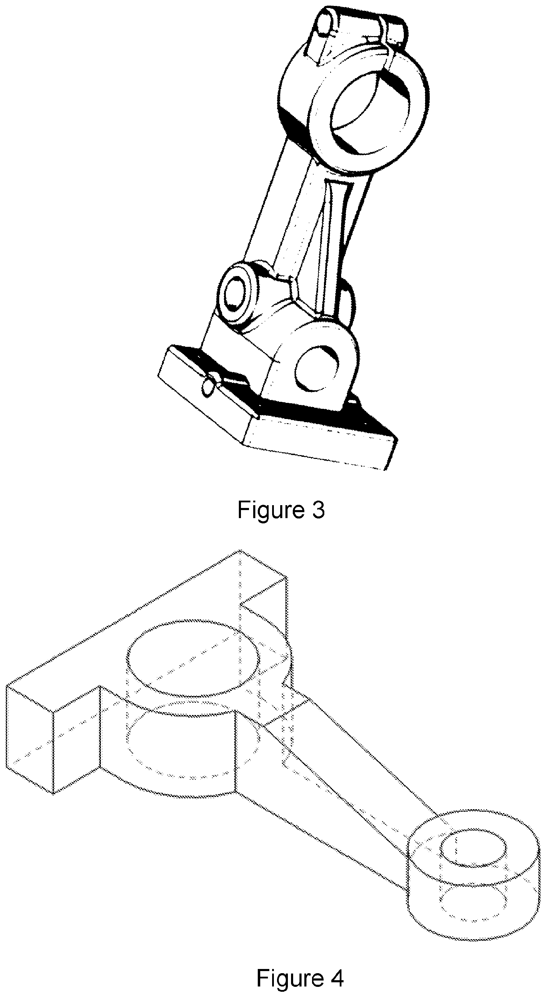

La Figure 3 illustre un exemple d'un modèle 3D d'une pièce. Pour simplifier la description des réalisations suivantes, la Figure 4 montre une version simplifiée du modèle 3D de la Figure 3, et cette version simplifiée sera utilisée dans la description qui suit. La pièce illustrée contient deux ouvertures circulaires de dimension différente dans ses parties supérieure et inférieure et une partie médiane laquelle relie les portions supérieure et inférieure.

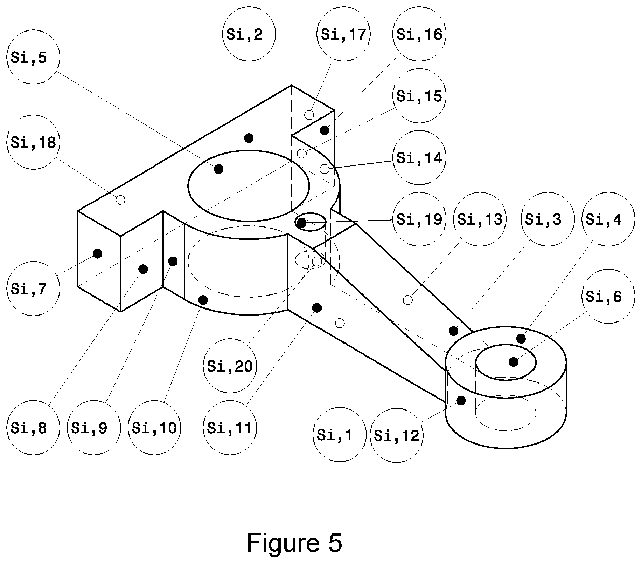

Dans la figure 5, les diverses faces sont marquées de Si,1 à Si,20. L'étiquetage est tout à fait arbitraire, et peut différer d'un modèle 3D à l'autre. Ainsi l'étiquetage Sm,f d'une face identifie la face f du modèle 3D m. Le descripteur dans cette réalisation pourrait consister en une liste de caractéristiques , telles le type du modèle 3D (Type), les paramètres dépendant du type (TypePar), le volume, dans le cas d'un corps solide, ou l'aire, dans le cas d'une face (Int(N)), l'aire pour un corps solide ou le périmètre pour une face (Int(N-1)), le centre de gravité (Gx,y,z), les moments d'inertie (M1,2,3), les axes d'inertie (Ai x,y,z avec i=1,2,3) et les dimensions de la boite englobante (Bx,y,z) pour chacun des corps solides composant le modèle 3D et pour le modèle 3D complet, ainsi que pour chacune des faces.

La représentation par les frontières ne respecte pas la propriété d'unicité, c'est-à-dire que plus d'une représentation par les frontières peuvent exister pour un modèle 3D donné. Or cette propriété d'unicité est essentielle à la comparaison des modèles 3D. Il est possible par exemple en utilisant des systèmes de modélisation différents (disons deux systèmes de CAO) que le découpage en faces de la frontière d'un modèle 3D ne soit pas toujours unique. Pour remédier à cette situation nous utilisons des faces "strictement continues G2". Ainsi, des faces peuvent être regroupées pour n'en former qu'une seule si la dérivée seconde géométrique, habituellement notée G2, est continue tout le long d'une arête commune à deux faces. De même, une face dont la surface sous-jacente ne serait pas continue G2 serait scindée en morceaux de sorte que la surface sous-jacente de chaque face soit continue G2. En procédant de cette manière, la propriété d'unicité est rétablie au niveau des faces de la représentation par les frontières.

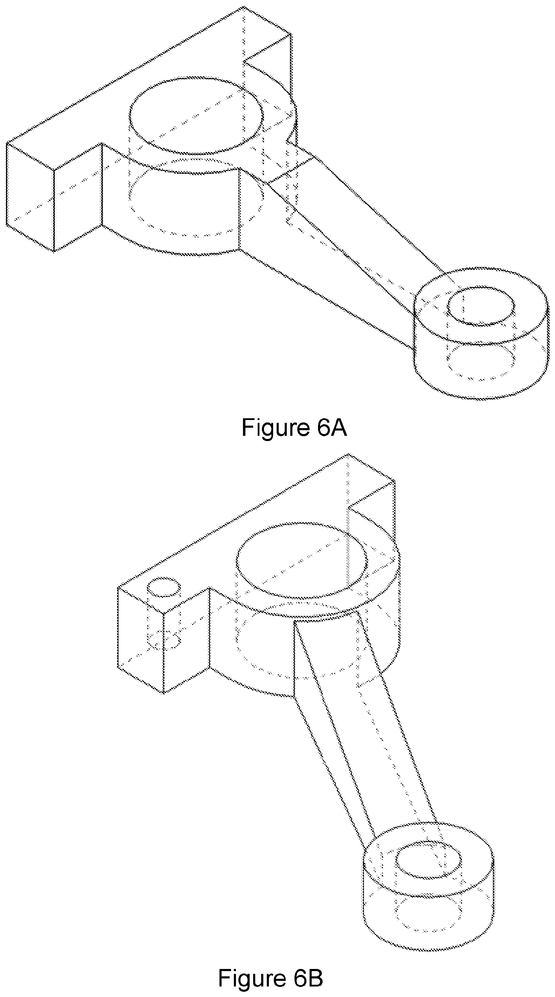

Le tableau 1 donne les valeurs des caractéristiques pour le modèle 3D de la figure 6a. Le lien entre l'identifiant d'un modèle 3D dans le descripteur (colonne Mod3D) et le modèle 3D lui-même est réalisé par une table de correspondance par exemple.

La figure 6.b présente un autre exemple de modèles 3D. Le tableau 2 donne les valeurs des caractéristiques de ses descripteurs.

Dans la Figure 1, l'étape de génération des descripteurs est S100. Tous les modèles 3D sont soumis à cette étape, laquelle peut néanmoins être effectuée à des moments différents. Des descripteurs convenables peuvent être stockés avec les données de modèles 3D ou séparément.

À la figure 2, des modèles 3D sont stockés dans un magasin de données S30. Il peut s'agir d'un seul magasin de données ou encore d'un stockage distribué de modèles 3D. Un générateur de descripteurs S32 lit les modèles 3D du magasin de données S30 et sauvegarde les descripteurs dans un deuxième magasin de données S34. Ledit magasin de données S34 peut être intégré au magasin de données S30, ou localisé séparément, même à distance.

Le système peut inclure un système de gestion de modèles 3D S40 lequel contrôle quels modèles 3D seront comparés. Un sélecteur ou générateur de modèle 3D de référence S42 permet à un opérateur de sélectionner ou de créer un modèle 3D de référence. Le descripteur du modèle 3D de référence peut être généré à l'aide du générateur de descripteurs S32 et introduit au moteur de recherche ou de comparaison S50. Le moteur S50 récupère les descripteurs du magasin de données S34.

Le système de la Figure 2 peut résider sur un poste de travail indépendant ou être distribué parmi différents ordinateurs et/ou serveurs afin de faciliter le traitement, le stockage et la gestion des données.

La figure 7A montre le modèle 3D de la Figure 4 sur lequel est superposé un second modèle 3D, soit celui de la figure 6B. Ce dernier présente des différences par rapport au modèle 3D de référence de la figure 6A, à savoir la partie médiane est plus longue (l'entre-axe est passé de 120mm à 150mm, et la partie médiane se connecte à la partie inférieure à un angle différent de 30 degrés. Le modèle 3D de la figure 6A est le modèle 3D de référence sélectionné à l'étape S102 de la figure 1, et le modèle 3D de la figure 6B est celui auquel la référence est comparée pour expliquer la méthode. On comprend que cette comparaison est réalisée pour chaque modèle 3D disponible.

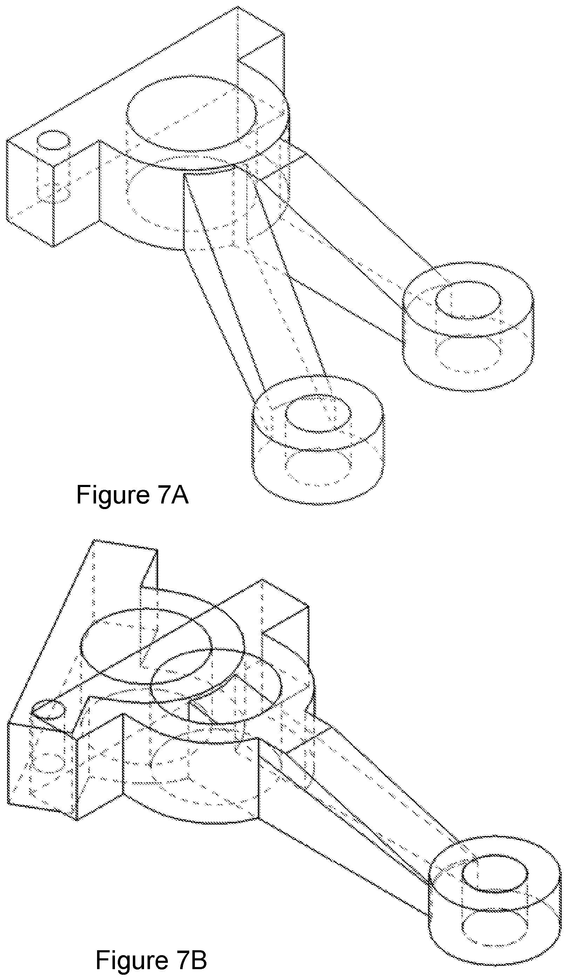

La figure 7B présente les deux modèles 3D dans une position relative différente. Les systèmes décrits dans l'art antérieur n'utilisent qu'une unique position relative pour comparer des modèles 3D entre eux. Cette position est alors déterminée soit, automatiquement à partir des repères propres à chaque modèle 3D, soit par un "best-fit" des deux modèles 3D, soit par un opérateur. L'approche adoptée dans les réalisations suivantes détermine à partir des caractéristiques de face des descripteurs toutes les positions relatives qui permettent de mettre en concordance des caractéristiques de formes (des sous-parties des modèles 3D initiaux) issues des modèles 3D comparés.

Bien qu'une comparaison au niveau des corps solides entre deux modèles 3D puisse produire des résultats utiles à des fins de recherche, elle ne constitue pas un moyen utile pour repérer un modèle 3D à l'intérieur d'un autre modèle 3D (plus complexe), lequel renfermerait une ou des parties du modèle 3D recherché. Une comparaison des faces permet une mise en concordance de celles-ci afin d'identifier les modèles 3D pouvant renfermer potentiellement le modèle 3D recherché. Cette concordance des faces est obtenue par un processus itératif de comparaison des descripteurs en deux étapes, soit une étape d'appariement basée sur les caractéristiques intrinsèques du modèle 3D, par exemple son aire ou ses moments d'inertie, suivie d'une étape de réconciliation basée sur les caractéristiques extrinsèques du modèle 3D, par exemple son centre de gravité ou ses axes d'inertie, ces caractéristiques dépendant du modèle 3D mais aussi du repère dans lequel il est décrit et de manière plus générale de son contexte.

L'identification (au sens étiquetage) des faces sera typiquement différente parmi des modèles 3D comparés; toutefois, dans le cadre de notre exemple simplifié, la numérotation est identique uniquement dans le but de faciliter la compréhension du processus. À l'aide de caractéristiques intrinsèques de faces du descripteur, des faces parmi les modèles 3D sont appariées. Par exemple, les valeurs des caractéristiques aire Int(N), périmètre Int(N-1), et des trois moments d'inertie M1,2,3 des faces Si,5; Si,18; Si,6 et Si,4 sont uniques et identiques et donc ces faces sont appariés entre les deux modèles 3D considérés avec un indice de confiance maximale de 1. En revanche, les valeurs intrinsèques pour les faces Si,7; Si,8; Si,16 et Si,17 ne sont pas uniques et entrainent de multiple appariements potentiels de faces, par exemple S1,7 avec {S2,7; S2,8; S2,16; S2;17} ou encore S1,9 avec {S2,9; S2,25}. L'indétermination sera levée lors de l'étape de réconciliation. Pour les faces S1,1; S1,2 et S1,3 avec S2,1; S2,2 et S2,3 respectivement, les valeurs des caractéristiques intrinsèques sont uniques mais certaines valeurs diffèrent entre les faces des deux modèles 3D comparés. Ces faces sont appariées mais l'indice de confiance est inférieur à 1. La manière de calculer cet indice peut varier, nous proposons ici une méthode simple pour alléger la compréhension, soit la sommation de l'indice accordé à chaque caractéristique considérée divisée par le nombre de caractéristiques considérées. Pour un paramètre quantitatif par exemple, l'indice vaut un moins la valeur absolue du rapport entre la différence des valeurs pour cette caractéristique et leur moyenne soit |(Vref-Vcomp/((Vref+Vcomp)/2)|, et pour un paramètre qualitatif, une table de valeurs correspondant aux cas de différence. La méthode est donnée à titre d'exemple et est définie autrement dans d'autres réalisations du processus. Cet indice participe à la détermination de l'indice de ressemblance entre les modèles 3D dans notre réalisation. Dans le cas général, le nombre de faces des deux modèles 3D comparés est différent et à la fin de cette étape certaines faces peuvent ne pas être appariées.

Le résultat de la comparaison des descripteurs pour notre exemple simplifié suivant la réalisation décrite après l'étape d'appariement est donnée dans le tableau 3.

Ce tableau montre une comparaison entre caractéristiques intrinsèques de corps solides qui montre un appariement imparfait (modèles 3D semblables mais non identiques) suivie d'une comparaison entre caractéristiques intrinsèques de faces, Plusieurs cas sont illustrés, soit des appariements uniques parfaits, des appariements multiples avec des valeurs de caractéristiques identiques, des appariements basés sur des valeurs de caractéristiques seulement partiellement identiques et donc avec un indice de confiance inférieur à 1. Les ambigüités sont levées dans une phase subséquente soit la réconciliation.

Le processus d'appariement a été décrit au niveau des faces d'un modèles 3D. On comprend qu'un processus similaire est applicable au niveau d'une pluralité de corps solides, s'ils existent dans les modèles 3D. L'appariement est réalisé en utilisant leurs caractéristiques intrinsèques, comme le volume (Int(N)), l'aire (Int(N-1)), les trois Moments d'inertie (M1,2,3) avec notre exemple de descripteur suivant le même principe. Le processus sert donc aussi à comparer des assemblages de modèles 3D par exemple, ou encore à trouver des sous-systèmes dans des systèmes plus complexes. Dès cette étape (étape S120 de la figure 1), l'indice de confiance correspond à un indice de ressemblance temporaire qui est utilisé pour augmenter l'efficacité de calcul dans le processus. Lorsqu'un modèle 3D possède un indice par rapport au modèle 3D de référence, qui tombe sous un seuil déterminé par l'opérateur, il n'est pas nécessaire d'approfondir plus la comparaison entre les descripteurs et l'indice de similarité (de ressemblance) temporaire (étape S122 dans la Figure 1) fournit une indication rapide sur les modèles 3D potentiellement similaires et permet ainsi de traiter des modèles 3D en grand nombre en ne procédatit pas au raffinement de la comparaison lorsque cela n'est pas requis.

L'appariement compare des modèles 3D ou des parties de celui-ci, lesquelles dans notre définition sont également des modèles 3D, que ce soit une face, un ensemble de faces (caractéristiques de formes), un ou plusieurs corps solides, en analysant des paramètres intrinsèques du descripteur. À ce stade chaque modèle 3D est considéré de manière isolée sans tenir compte notamment de sa position relative par rapport aux autres modèles 3D.

Bien que l'échelle d'un modèle 3D puisse généralement être considérée comme étant bien définie, et ainsi qu'un indice de confiance faible sur des caractéristiques dimensionnelles peut constituer un motif pour rejeter un appariement, on comprend que dans certains cas, un facteur d'échelle peut être déterminé lors du processus d'appariement des faces, et que l'appariement puisse ainsi être réalisé, pour un facteur d'échelle donné.

L'ajout des données dans les lignes du tableau pour chaque modèle 3D qui est comparé au modèle 3D de référence constitue l'étape S124 de la figure 1. Lorsqu'un nombre suffisant de modèles 3D similaires est atteint ou lorsque tous les descripteurs disponibles ont été comparés, à l'étape S126 le processus de raffinement de la comparaison se poursuit. Dès lors, on peut identifier les modèles 3D les plus semblables en fonction par exemple du nombre de faces appariées ou du rapport du total des aires des faces appariées sur la somme des aires de toutes les faces ou toute autre fonction qui déterminerait un indice de ressemblance temporaire. Dans la figure 1, le processus continue avec l'étape de la réconciliation des modèles 3D, lesquels sont selon notre définition une ou des faces ou un ou des corps solides. Il pourrait alors se concentrer sur les modèles 3D les plus prometteurs.

Relativement à la Figure 2, le moteur de comparaison S52 effectue la comparaison des descripteurs et le stockage des données de comparaison présentées dans les tableaux est réalisé dans le magasin de données S54. Le moteur S50 contrôle le processus et effectue le calcul de l'indice de similarité.

L'étape de réconciliation S140 de la figure 1 consiste à prendre en compte les caractéristiques extrinsèques des descripteurs et notamment les positions relatives des modèles 3D entre eux. À partir des appariements certains (indice de confiance = 1), des matrices de changement de repère sont déterminées lesquelles repositionnent les modèles 3D comparés dans un repère commun, par exemple, le repère du modèle 3D de référence. La détermination de ces matrices est une opération assez routinière et connue dans l'état de la technique. A ce stade, plusieurs matrices de changement de repère sont créées. En les appliquant aux modèles 3D, on constate que certaines d'entre elles ne réconcilient que les modèles 3D qui ont servis à les déterminer. Leur pertinence est faible et elles sont discriminées à l'étape S142.

On comprend que l'on peut calculer les transformations ou les matrices de changement de repère entre toutes les caractéristiques géométriques des descripteurs (parties des modèles 3D, comme par exemples des faces) et ensuite retrouver au moins un groupe de transformations identiques (tenant compte des tolérances de calcul), comme on peut calculer une transformation pour une première caractéristique (ex. une première face) et ensuite tenter d'appliquer cette transformation à d'autres caractéristiques. De cette manière, on peut développer un groupe de caractéristiques ayant une transformation commune.

Pour chaque repositionnement obtenu en appliquant les matrices de changement de repère retenues, la comparaison des caractéristiques extrinsèques est effectuée (étape 144). Dans notre exemple, deux matrices sont ainsi retenues. Une première matrice M1 positionne les modèles 3D tel qu'illustré par la figure 7A. Les faces Si,5 Si,6 et Si,18 qui étaient déjà appariées avec certitude sont réconciliées et concordent, elles sont déclarées identiques pour cette mise en position particulière. En appliquant cette matrice, les ambiguïtés d'appariement des faces Si,7; Si,8; Si,9; Si,15; Si,16 et Si,17 sont levées. Ces faces sont réconciliées et sont aussi déclarées identiques pour cette mise en position. Enfin en comparant les caractéristiques extrinsèques des descripteurs des faces S1,2 et S1,10 avec S2,10 et S2,14 on constate que plusieurs valeurs sont identiques et d'autres sont différentes. Ces faces sont réconciliées avec un indice de confiance inférieure à 1. Elles sont différentes et ces différences sont qualifiables à partir de la comparaison des descripteurs comme nous le montrerons à l'étape du marquage. L'application de la deuxième matrice M2 positionne les modèles 3D tels que représentés par la figure 7B. Les faces Si,4 et Si,6 appariées avec certitude, sont réconciliées, concordent et donc sont déclarées identiques pour cette seconde mise en position. Enfin les faces Si,11; Si,12 et Si,13 sont réconciliées avec un indice inférieure à 1 et donc avec des différences pour cette mise en position particulière. Dépendant du seuil fixé sur l'indice de confiance, une face telle que Si,3 est aussi réconciliée. Il est aussi possible que plusieurs matrices de changement de repère conduisent à réconcilier des faces plusieurs fois. Dans ce cas, la réconciliation donnant le meilleur indice de confiance est conservée. Ces matrices ne contribuent pas à résoudre toutes les ambiguïtés dans tous les cas et certaines faces restent orphelines. Il s'agit de nouvelles faces ou de faces fortement modifiées.

Le tableau 4 complété par les données ajoutées par l'étape de réconciliation est présenté pour notre exemple. Ce tableau peut être stocké en conservant toutes les données ou uniquement celles d'intérêt pour la suite du processus et les besoins de l'opérateur.

L'on s'aperçoit que le principe du multi positionnement introduit dans cette invention redéfinit complètement la notion de comparaison et de différence entre modèles 3D et autorise la comparaison de parties de modèles 3D (form features). Ainsi la comparaison peut être effectuée, en utilisant toutes les matrices de mise en positon, en privilégiant une ou plusieurs matrices particulières, voire même en contraignant la détermination d'une matrice basée sur certaines caractéristiques des descripteurs sélectionnées par l'opérateur. On comprend qu'à l'étape S146, il est possible de calculer des indices de ressemblances qui dépendent de ces choix.

On peut maintenant tronquer le tableau des données de comparaison afin d'y enlever les appariements multiples et ambigües de faces issus de l'étape d'appariement en raison des valeurs de leurs caractéristiques intrinsèques, et dont la non pertinence est montrée lors de la réconciliation (étape S148). Le tableau 5 illustre les données de comparaison après le nettoyage pour notre exemple.

Le processus de raffinement de la comparaison se poursuit jusqu'à ce qu'un nombre suffisant de modèles 3D similaires soit atteint ou que tous les descripteurs disponibles aient été comparés, à l'étape S150.

On comprend qu'un tel processus de comparaison entre des modèles 3D, est utile pour de nombreuses applications comme retrouver des modèles 3D similaires, les classer en fonction d'un indice de ressemblance, faire une classification (clustering) de ces modèles 3D, mettre en évidence les caractéristiques identiques ou différentes ou encore permettre une identification et une réconciliation des références lorsqu'un modèle 3D est substitué à un modèle 3D de référence.

Le moteur de réconciliation S56 (voir Figure 2) effectue les opérations susmentionnées et met à jour les données dans le magasin de données S54.

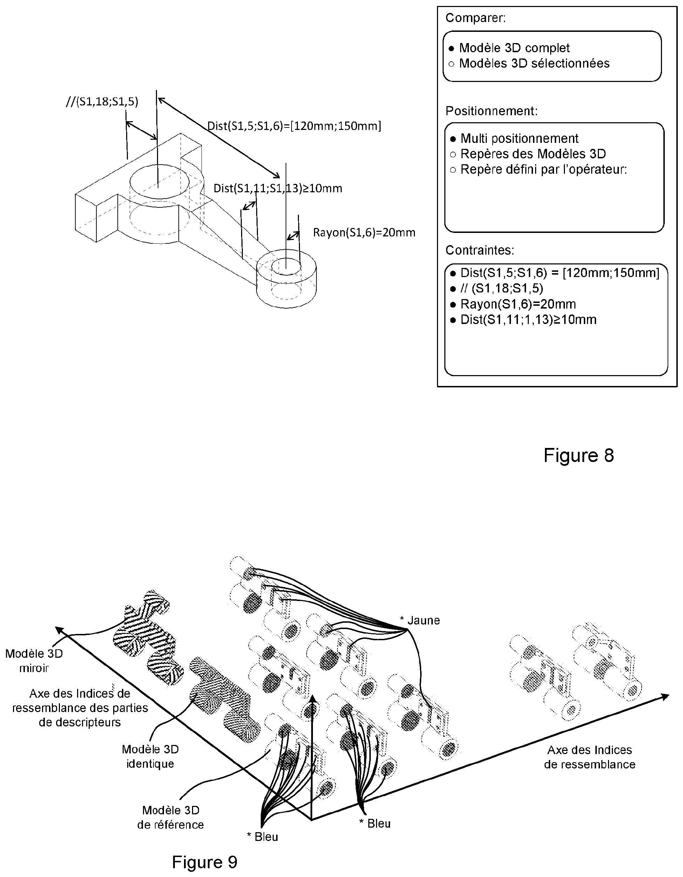

En référence à la Figure 2, les modèles 3D possédant la plus grande ressemblance par rapport au modèle 3D de référence, identifiés comme tels par le moteur S50 lequel s'appuie sur les données du tableau dans le magasin de données S54 alimenté par les moteurs S52 et S56, sont désormais prêts à être présentés à l'opérateur grâce au système d'affichage S46. Le système S46 génère la vue désirée des modèles 3D. Pour ce faire, il accède aux modèles 3D stockés dans le magasin de données S30 et le moteur de marquage S45 utilise des données de comparaison du magasin de données S54 afin de marquer les faces identiques ou différentes, ou encore d'autres caractéristiques des modèles 3D. L'opérateur sélectionne les paramètres ou critères de marquage désirés grâce à l'interface S44, laquelle permet également de sélectionner les propriétés et fonctions qui déterminent la disposition des modèles 3D dans l'espace de dimension 3 générée par le système S46. Dans certaines réalisations S46 utilise un système de CAO ou encore un navigateur internet (web browser) pour l'affichage des résultats en 3D. La disposition et le marquage des modèles 3D affichés varient selon les besoins de l'opérateur. Par exemple dans certains cas, l'opérateur veut mettre en évidence les parties identiques des modèles 3D pour une mise en position particulière, pour de multiples mises en position ou encore mettre en évidence des différences d'une ou plusieurs caractéristiques. Cette manière de communiquer la comparaison simultanément de plusieurs modèles 3D basée sur le marquage et la position des modèles 3D dans une scène en 3D, telle qu'illustrée à la Figure 9 est totalement inédite.

On comprend que lorsque des modèles 3D sont comparés dans le processus proposé, plusieurs types de différences entre face, ensembles de faces (form features) et corps solides sont déterminés. Le marquage les distingue suivant les requêtes formulées par l'opérateur. Voici quelques exemples illustrant des types de différences en fonction des besoins de l'opérateur. Dans le premier exemple, l'opérateur cherche dans un ensemble de modèles 3D, des caractéristiques de formes identiques à celles présentent dans le modèle 3D de référence sans les préciser. Dans ce cas, le processus met en œuvre l'appairage, la réconciliation, le multi repositionnement et marque les faces en conséquence. Les faces Si,4; Si,5; Si,6; Si,7; Si,8; Si,9; S1,15; Si,16; Si,17; Si,18 respectivement sur les modèles 3D de référence (i=1) et comparé (i=2), concordent totalement pour l'une des mises en position données et sont donc qualifiées d'identiques et marquées en conséquence (comme par exemple par une couleur, soit bleu). Les faces Si,1; Si,2; Si,11; Si,13 et la face S1,10; S1,14 avec la face S2,10 des modèles 3D sont d'abord appariées avec un indice de confiance faible lequel est revu à la hausse lors de la réconciliation. Ces faces sont finalement marquées comme géométriquement identiques avec des topologies différentes (utilisation par exemple de la couleur verte) car elles partagent les mêmes caractéristiques géométriques (axe et rayon pour les faces cylindriques S1,10; S1,14 et S2,10 et normal et position pour les faces planes Si,1; Si,2; Si,11; Si,13) mais diffèrent sur d'autres valeurs des descripteurs qui caractérisent leur topologie (périmètre par exemple dans nos descripteurs). L'appariement et la réconciliation des descripteurs de la face Si,13 des modèles 3D comparés ne permettent pas de conclure avec une grande confiance qu'il s'agit de la même face modifiée. Rendu à ce stade il reste peu de faces non réconciliées et il s'agit du meilleur choix restant. Dans ce cas, la caractéristique Type est identique et dépendant du seuil sur l'indice de confiance, elle sera déclarée "réconciliée et différente" (par exemple couleur mauve) ou tout simplement "non réconciliée et nouvelle" (par exemple couleur rouge). Les faces sont différentes tant du point de vue de leur géométrie que de leur topologie pour toutes les remises en position retenues. Les faces S2,19 et S2,20 quant à elles sont déclarées "non-réconciliées", donc nouvelles (couleur rouge).

Dans un autre exemple, l'opérateur sélectionne, par l'intermédiaire de l'interface 44 (figure 2), une partie du modèle 3D (qui devient de facto le modèle 3D de référence), qui représente les faces fonctionnelles ou les faces en contact avec d'autres composants (interfaces), soit pour illustrer, les faces S1,5; S1,1; S1,18 qui servent également à définir une mise en position pour l'étape de la réconciliation, ainsi que les faces S1,6; S1,4. Pour faciliter l'interprétation des résultats, il demande que les faces identiques sur les modèles 3D trouvés soit marquées en bleu, que les faces réconciliées et géométriquement identiques mais dont la topologie est différente soient marquées en cyan et finalement que les autres faces (non prise en compte, non réconciliée, nouvelles) soient grisées et transparentes. Avec les modèles 3D de la figure 6A et 7B, on obtient S2,5; S2,18 identiques (donc en bleu), S2,1; S2,4; S2,6 géométriquement identiques (donc en cyan) et toutes les autres faces ne sont pas considérées (donc gris, transparent).

On comprend que l'opérateur, par l'intermédiaire d'une interface 44 appropriée peut définir des contraintes extrêmement précises comme par exemple imposée l'entre-axe et les diamètres des faces Si,5 et Si,6 ou encore le parallélisnie et la distance entre Si,11 et Si13. Toutes ces contraintes sont calculables à partir des caractéristiques des descripteurs présentés dans cette réalisation.

Le fait d'afficher un modèle 3D avec un étiquetage ou encore avec des textures ou des couleurs différentes pour des faces particulières est connu dans l'état de la technique.

Les différences sont représentées par des couleurs, des transparences, des textures, des hachures, des annotations ou tout autre effet graphique que nous regroupons sous le terme de marquage. La ressemblance, c'est à dire moins de différences suivant les critères de l'opérateur, entre les modèles 3D est représentée par leur position dans l'espace 3D.

On comprend qu'une vaste gamme de marquage peut être utilisée. Ainsi, la similarité est exprimée par les positions respectives dans l'espace 3D des modèles 3D obtenues par la fonction qui calcule l'indice de ressemblance, mais elle peut également être appréciée de façon à partir du marquage des différences des modèles 3D. Par exemple, si un perçage comparé à un perçage du modèle 3D de référence est plus petit en diamètre mais que son axe est le même, il sera marqué d'une certaine façon; par contre, si son diamètre et son axe sont différents, ce perçage est marqué d'une autre façon pour différencier les deux types de différences.

Dans certaines réalisations, le processus de comparaison des descripteurs est influencé par la définition de caractéristiques d'intérêt ou encore par celles au contraire qui ne présentent pas d'intérêt. Cette définition peut être précisée par l'opérateur de façon explicite ou implicite. À l'étape S152 de la figure 1, les modèles 3D sont sélectionnés selon les indices de ressemblance et les critères exprimés par l'opérateur. Les résultats sont mis en forme et affichés à l'étape S160. Parmi d'autres formes possibles, l'affichage des modèles 3D dans un espace 3D comme l'illustre la figure 9, avec la mise en évidence par un marquage, tel que décrit plus haut, des similarités et des différences et l'utilisation du positionnement dans l'espace des modèles 3D est une nouveauté et représente la manière privilégiée de communiquer les résultats. On comprend que ces résultats peuvent également être transmis sous une forme textuelle (tableau, liste ou autre forme).

La Figure 8 montre le modèle 3D simplifié de la figure 4 et un exemple d'interface pour la définition des contraintes de comparaison. Dans le cas présenté, le modèle 3D complet est pris en compte pour faire la comparaison en autorisant le multi repositionnement pour déterminer la ressemblance, et des contraintes ont été imposées comme la distance entre les axes des cylindres Si,5 et Si,6 doit être comprise entre 120 et 150mm les faces Si,18 et tSi,5 doivent être parallèles, Si,6 doit avoir un rayon de 20mm et finalement la distance entre les faces Si,11 et Si,13 doit être supérieure à 10mm. La détermination de ces contraintes peut se faire notamment à l'aide de l'interface de détermination de contraintes S48 tel que montré à la figure 2. L'opérateur a la possibilité de définir si tout le modèle 3D est pris en considération dans le processus ou si seulement une sous-partie de celui-ci est à considérer. Dans ce cas, Il sélectionne les sous-ensembles du modèle 3D à retenir (qui sont aussi des modèles 3D) et pour chaque sous-ensemble il indique s'il doit être identique ou seulement similaire dans les modèles 3D comparés. L'opérateur choisit également s'il autorise le multi repositionnement ou impose un repère de comparaison soit celui des modèles 3D ou un repère construit à partir de contraintes qu'il impose. Enfin, l'opérateur peut définir des contraintes auxquelles il apporte une plus grande importance, comme un entre-axe compris entre 120 et 150mm pour les deux cylindres Si,5 et Si,6, un rayon de 20mm pour le cylindre Si,6 et une distance supérieure ou égale à 10mm pour les faces Si,11 et Si,13. L'opérateur construit donc les contraintes directement sur les caractéristiques explicites des descripteurs (Rayon de Si,6 = 20mm) mais également implicites (Distances entre axes Si,5 et Si,6 ou parallélisme entre Si,18 et Si,5). De telles caractéristiques implicites sont ajoutées dans les tableaux contenant les résultats de comparaison (colonnes supplémentaires) pour participer au calcul de l'indice de ressemble.

Cette manière de définir des contraintes ressemble à celles que proposent les systèmes de CAO pour contraindre des esquisses ou des assemblages et est connue dans l'état de la technique.

On comprend que l'inventaire des propriétés ou contraintes disponibles, leur mode de sélection, leur disposition et ordonnancement, ainsi que la manière dont elles sont pondérées peuvent faire l'objet d'une multitude de variations sans pour autant modifier la fonctionnalité sous-jacente. Plutôt que d'offrir une simple sélection binaire (distinguant une sélection « retenue/importante » d'une autre « non-retenue/non-importante »), l'interface pourrait, par exemple, accepter une valeur de pondération exprimée en pourcentage d'importance ou une autre valeur calibrée. De même, l'opérateur peut éliminer des parties de modèles 3D qu'il estime insignifiant pour sa requête, comme les corps solides inférieures à une certaine dimension (taille de la boite englobante) ou volume, ou encore des faces dont l'aire serait inférieure à un certain pourcentage de l'aire totale du modèle 3D (simplification du modèle 3D). Il est tout aussi possible de cotitraindre la comparaison par un volume d'occupation maximale (réservation d'espace dans un assemblage).

Durant le processus de comparaison, des contraintes comme par exemple, celle exprimant la distance entre les deux cylindres peuvent servir de filtre (GoiNo Go) ou intervenir seulement au marquage en montrant que la contrainte est satisfaite ou au contraire non satisfaite. Ces contraintes interviennent éventuellement aussi au niveau du calcul de l'indice de ressemblance qui peut alors être vu comme un indice de conformité aux contraintes.

On comprend que lorsque les contraintes sont modifiées, tout le processus peut être recommencé ou simplement le calcul de l'indice de ressemblance et le marquage des modèles 3D déjà sélectionnés.

Dans certaines réalisations, des modèles 3D sont ordonnés suite au processus de comparaison basé sur l'appariement et la réconciliation des descripteurs en fonction de l'indice de ressemblance calculé. La figure 9 illustre un exemple de huit modèles 3D d'une pièce de charnière qui ressemblent au modèle 3D de référence (c'est-à-dire au modèle 3D ayant servi à la comparaison aux fins de la recherche présentée) positionnés dans une scène 3D (par exemple un assemblage dans les systèmes de CAO) suivant une vue isométrique dont l'opérateur peut évidemment modifier le point de vue.

Le modèle 3D ayant servi de référence est positionné à l'origine (soit le coin en bas à droite), les faces en bleu (repérées par une *) sont prises en compte dans le marquage des différences après la comparaison, les faces en gris (faces non repérées) ne seront pas marquées qu'elles soient identiques ou différentes pour faciliter l'interprétation des résultats par exemple. Les modèles 3D semblables sont positionnés dans l'espace 3D est utilisant des critères associés aux trois axes. Le marquage (couleurs, textures, transparences, annotations, etc.) peut représenter d'autres critères ou information. En particulier, dans cette figure, l'un des axes est utilisé pour représenter un indice de ressemblance. Plus un modèle 3D diffère du modèle 3D de référence et plus la distance augmente selon cet axe. Des modèles 3D qui possèdent un indice de ressemblance du même ordre de grandeur sont regroupés selon le second axe. Ainsi dans la première rangée directement à côté du modèle de référence apparaissent deux modèles 3D, l'un identique et l'autre miroir (symétrie plane). Dans la deuxième rangée est positionné le seul modèle 3D trouvé qui est différent mais satisfait à toutes les contraintes (aucune face en jaune, soit aucune face repérée dans la figure jointe). Dans les rangées suivantes, apparaissent des modèles 3D qui ne satisfont pas toutes les contraintes et qui diffèrent de plus en plus du modèle de référence. Le premier modèle 3D de la troisième rangée a une rainure différente et les faces sont marquées en conséquence (en jaune, soit repéré par une * dans cette figure). Le modèle suivant différent au niveau des quatre perçages et de l'alésage (toutes les faces repérées par *).

Le troisième axe qui n'est pas utilisé dans cet exemple peut servir à représenter une autre information comme les versions, la provenance, les états de fabrication ou toute autre classification des modèles 3D qui représente un intérêt pour l'opérateur.

On comprend que le modèle 3D de référence peut être dérivé d'un composant (pièce ou mécanisme) existant numérisé ou encore d'un modèle 3D esquissé plus ou moins grossièrement par l'opérateur à l'écran. Dans ce dernier cas, l'opérateur peut avoir omis certains détails qui apparaissent néanmoins parmi les modèles 3D résultant de la recherche. On comprend qu'une interface autorise l'opérateur à basculer du modèle de référence initial vers l'un des modèles 3D figurant parmi les résultats de la recherche. Lorsque le modèle 3D de référence est substitué, l'opérateur peut facultativement maintenir les contraintes de la comparaison précédente ou en définir de nouvelles.

On comprend que le système de comparaison de modèle 3D décrit ci-dessus peut constituer un outil puissant dans la recherche, l'analyse ou l'organisation des modèles 3D. Dans de nombreux milieux industriels et appliqués, l'utilisation du système ainsi que des méthodes décrites ci-dessus permettent un gain de temps tout au long du cycle de vie des produits, notamment au stade de la conception et de la fabrication des produits.

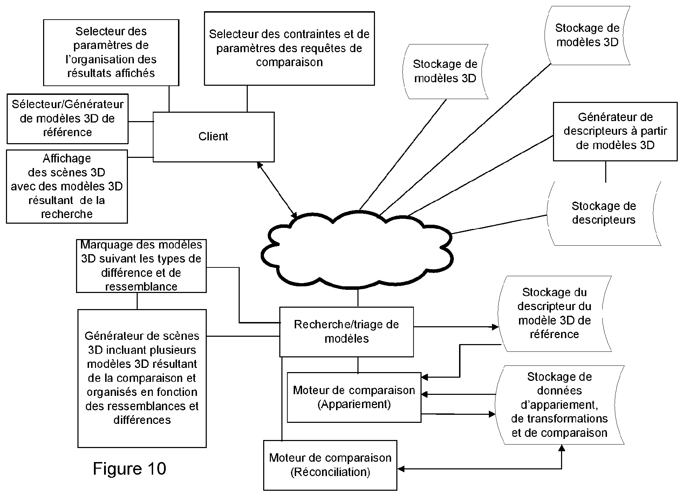

Tel qu'illustré à la figure 10, le système de la figure 2 peut être déployé de façon distribuée sur plusieurs ordinateurs, sur la toile (le web) ou sur un intranet, permettant un accès à distance à un opérateur à des magasins de données de modèles 3D, à des magasins de descripteurs, à des moteurs de recherche et de comparaison, de marquage ou aux autres modules complémentaires. Dans l'exemple de la figure 10, les tâches de recherche et de comparaison sont effectuées par un serveur distant du poste de travail de l'opérateur. Le moteur de marquage et de calcul de la scène 3D associée, accompagnent le serveur de recherche. Dans une autre réalisation, il pourrait aussi être du côté du client. La scène 3D et les modèles 3D sont envoyés à l'opérateur pour une exploitation dans un fureteur internet (web browser) par exemple. De même, le stockage des descripteurs est, d'après l'illustration qui en est faite, hébergé à distance. La génération des descripteurs peut constituer un service séparé pour les magasins de données de modèles 3D. Le système de la figure 10 montre également trois magasins de données à distance distincts de modèles 3D.

L'utilisation d'un tel système permet à un opérateur de fureter, de rechercher, et de comparer des modèles 3D d'une pluralité de sources depuis un seul et même poste de travail client.

L'utilisation d'un tel système permet à un opérateur de verser (uploader, télécharger) ses modèles 3D existants pour fins de génération de descripteurs en utilisant un service à distance, que ses modèles 3D soient pour recherche et comparaison par lui et lui seul, ou pour une recherche et comparaison faites par d'autres également.

Bien qu'elle ait été décrite à l'aide d'une ou plusieurs incarnations préférées, il faut bien comprendre que la présente invention peut être utilisée, employée et/ou incarnée dans une multitude d'autres formes. Ainsi, les revendications qui suivent doivent être interprétées de façon à inclure ces différentes formes tout en restant à l'extérieur des limites fixées par l'art antérieur.

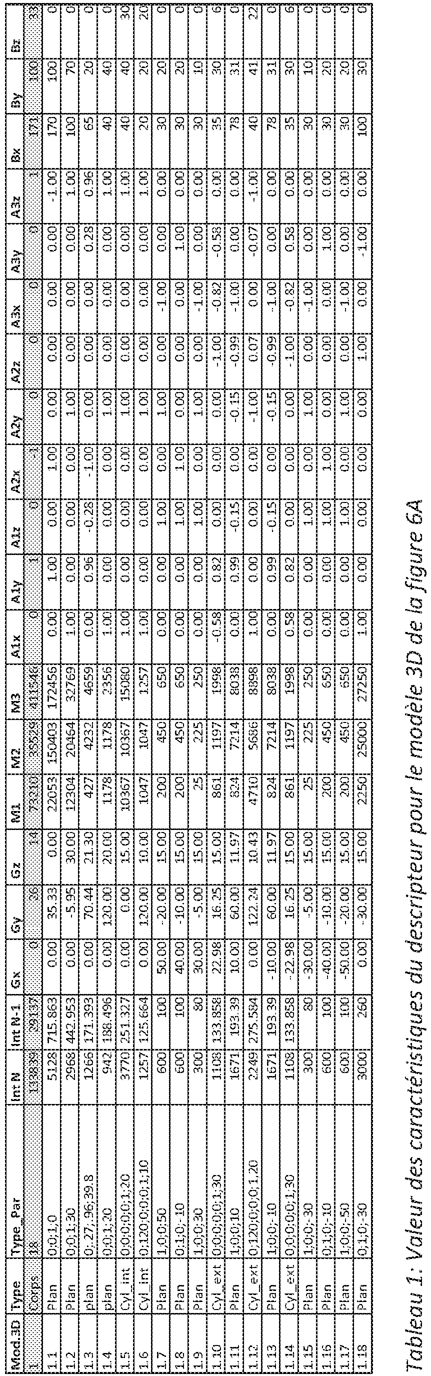

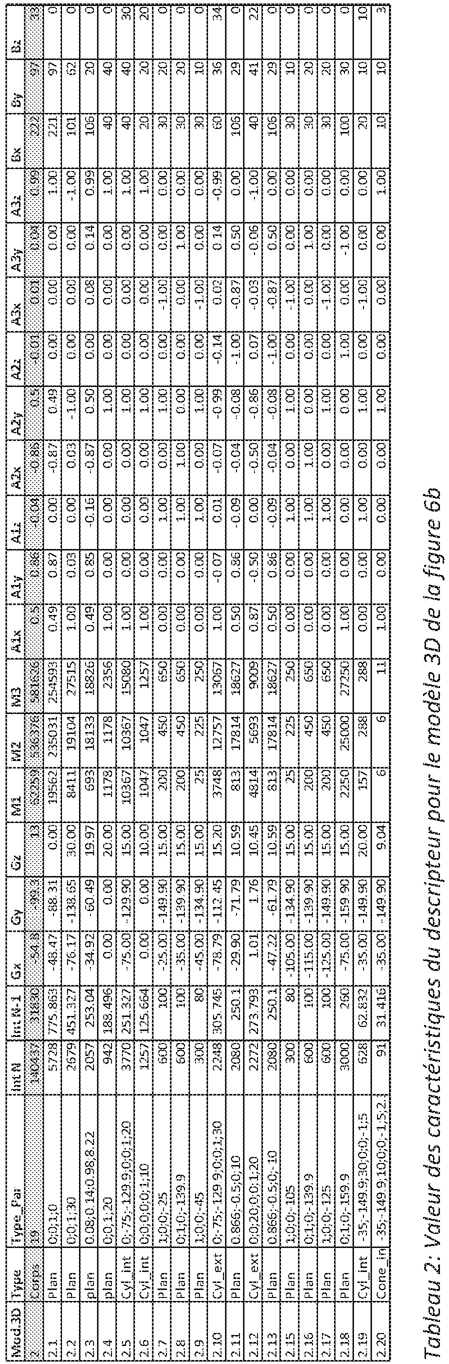

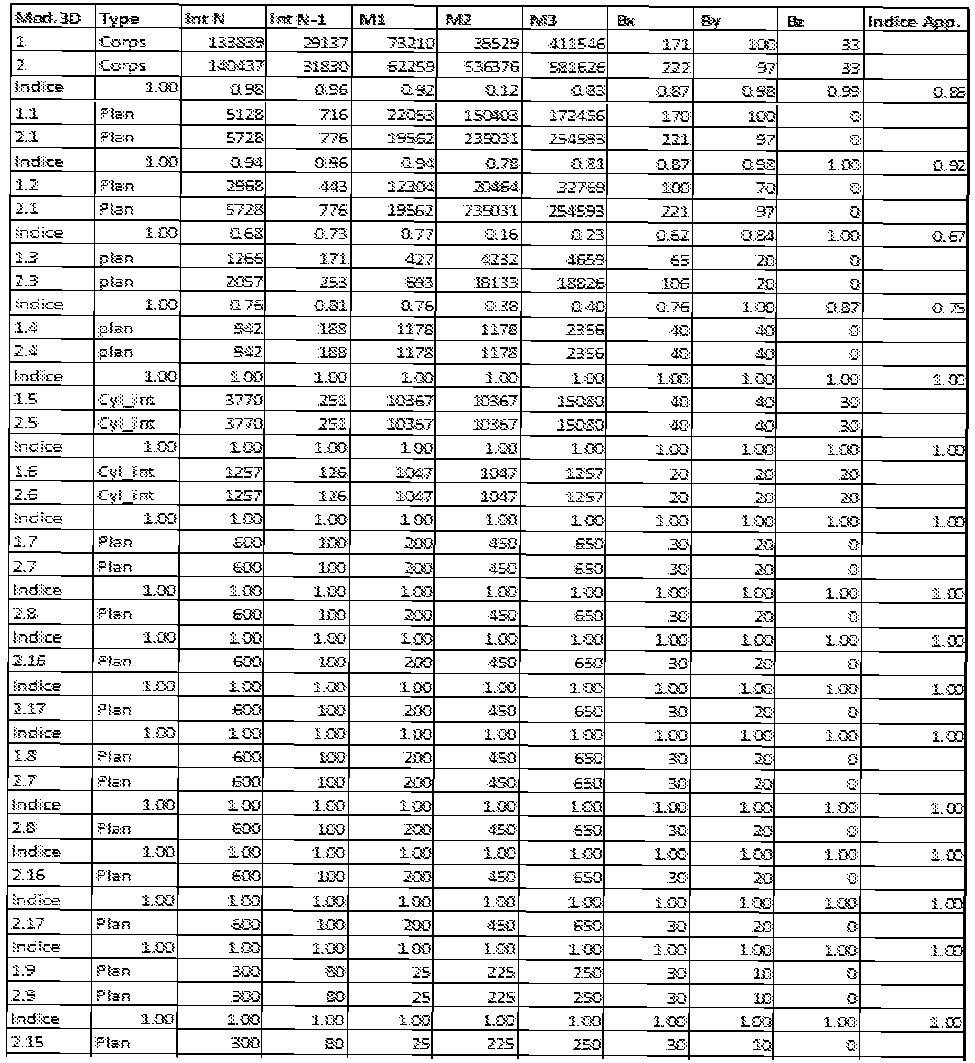

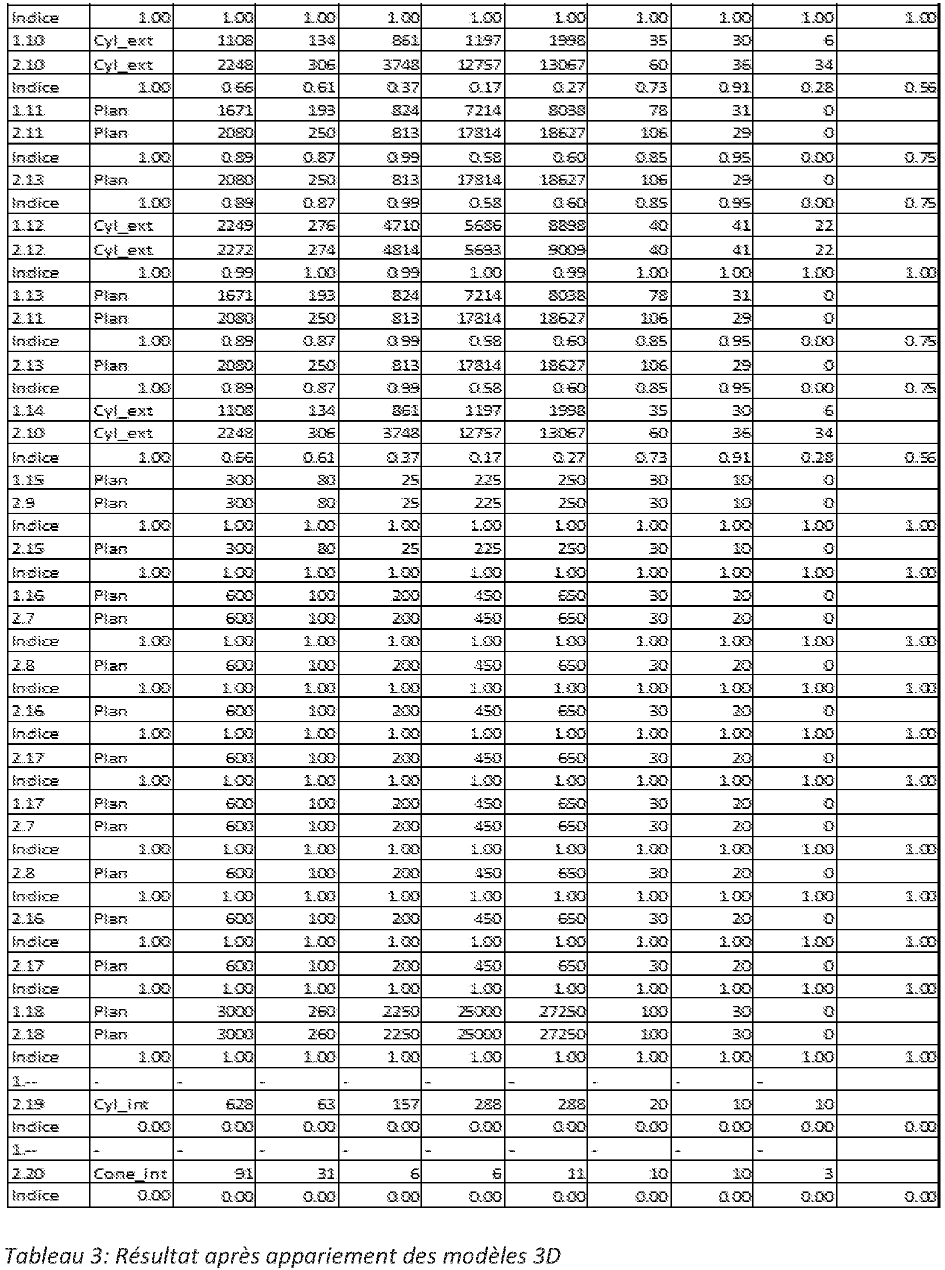

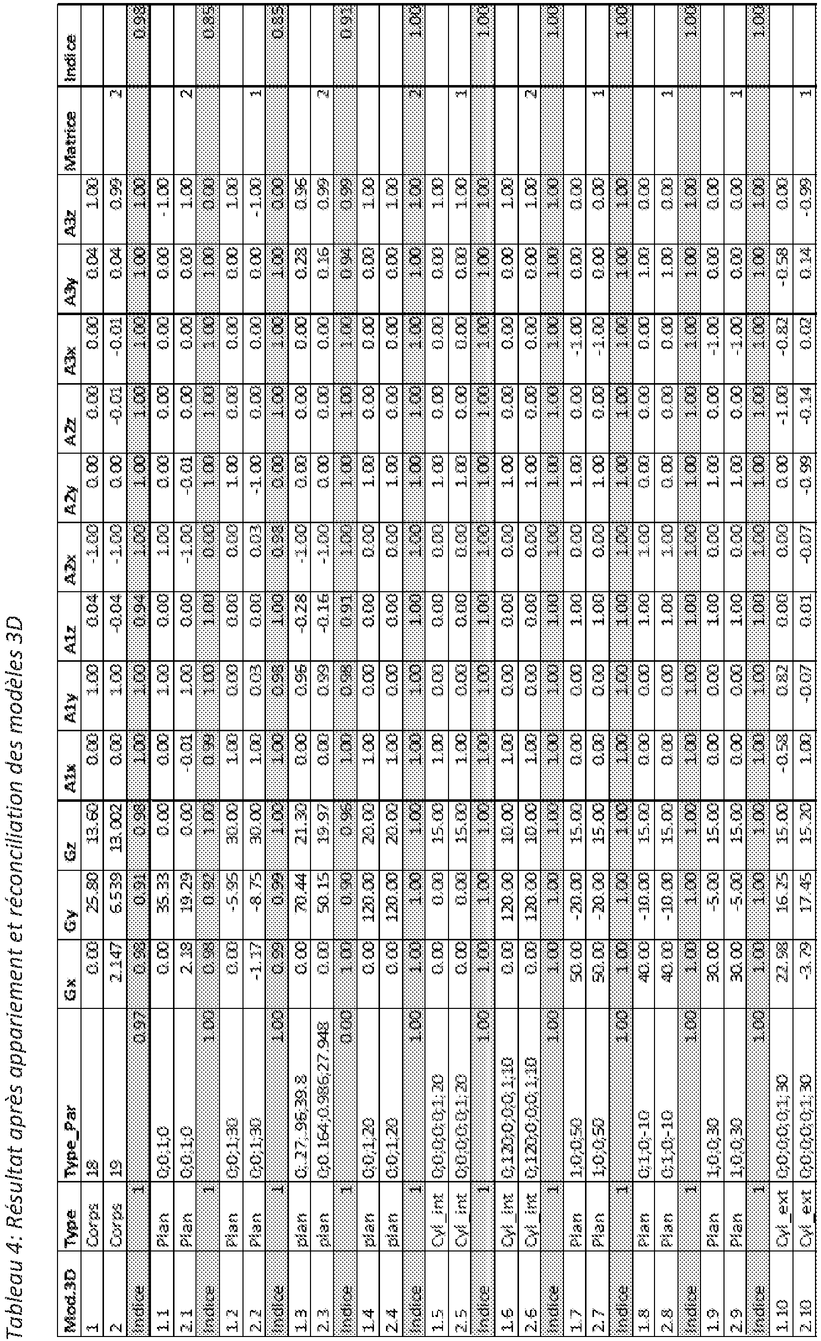

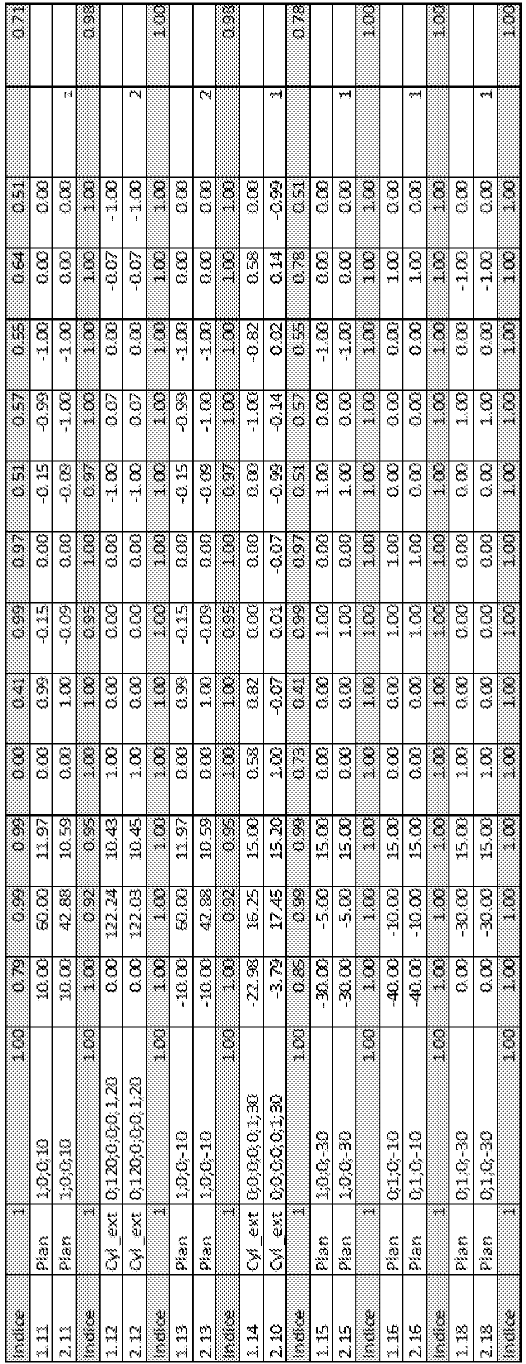

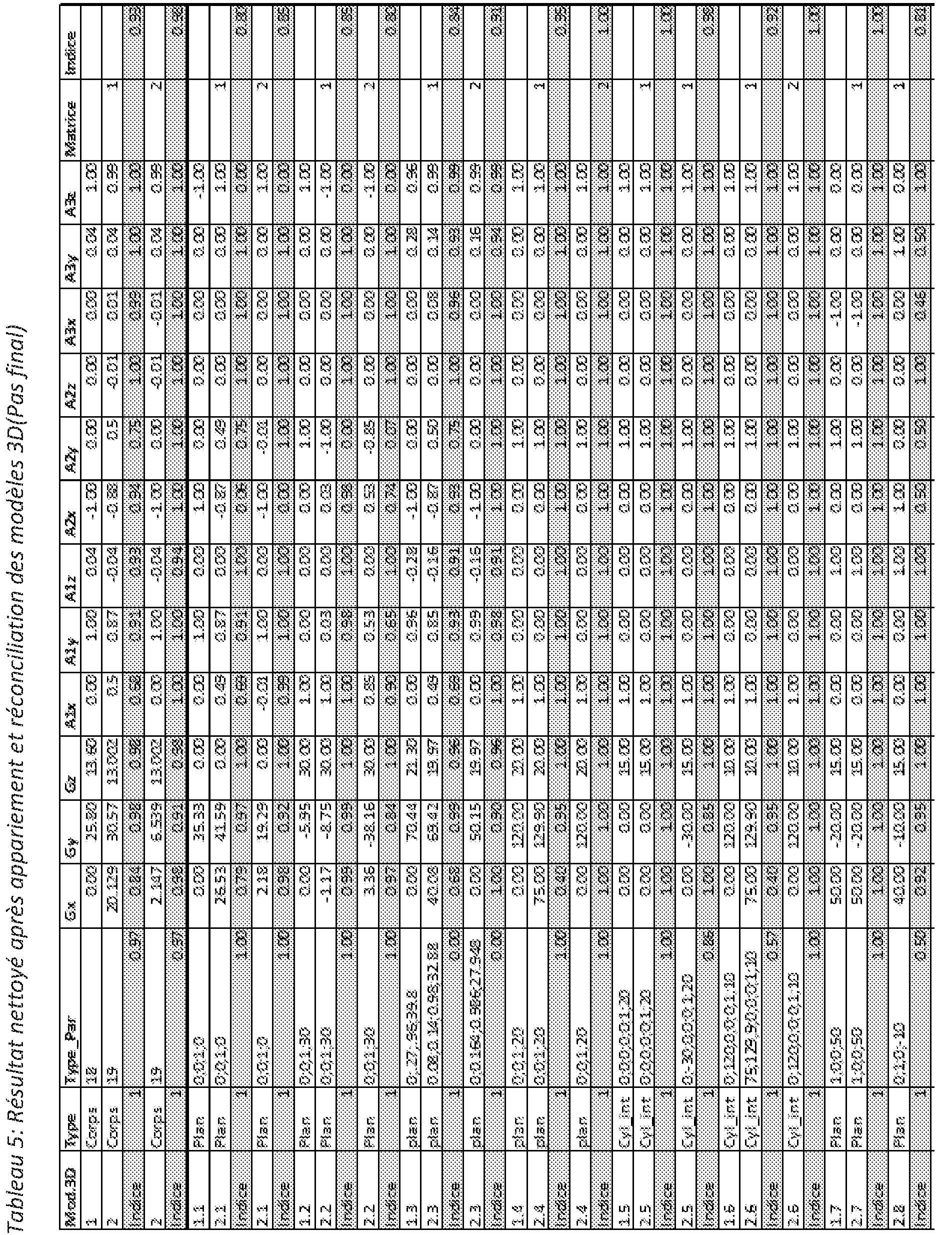

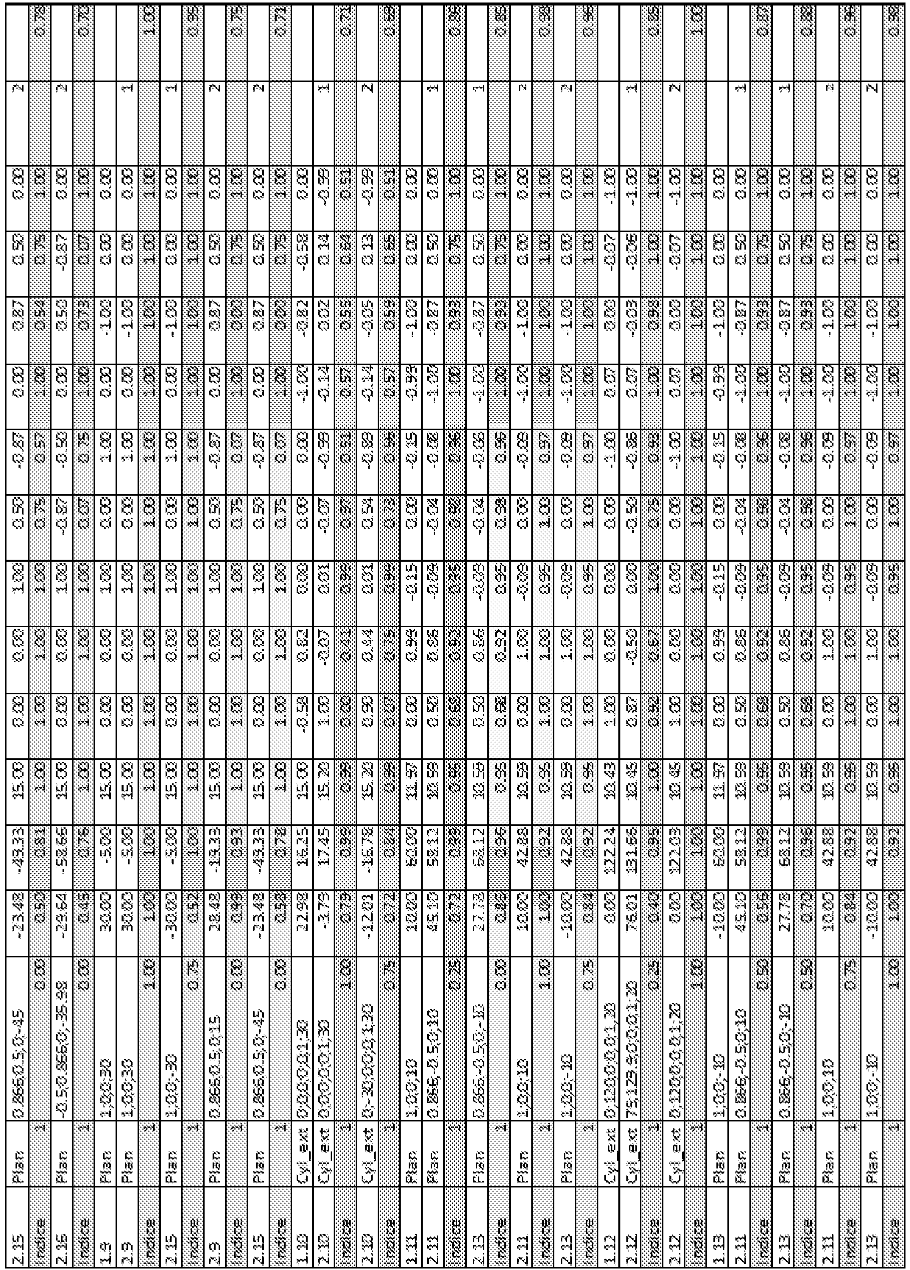

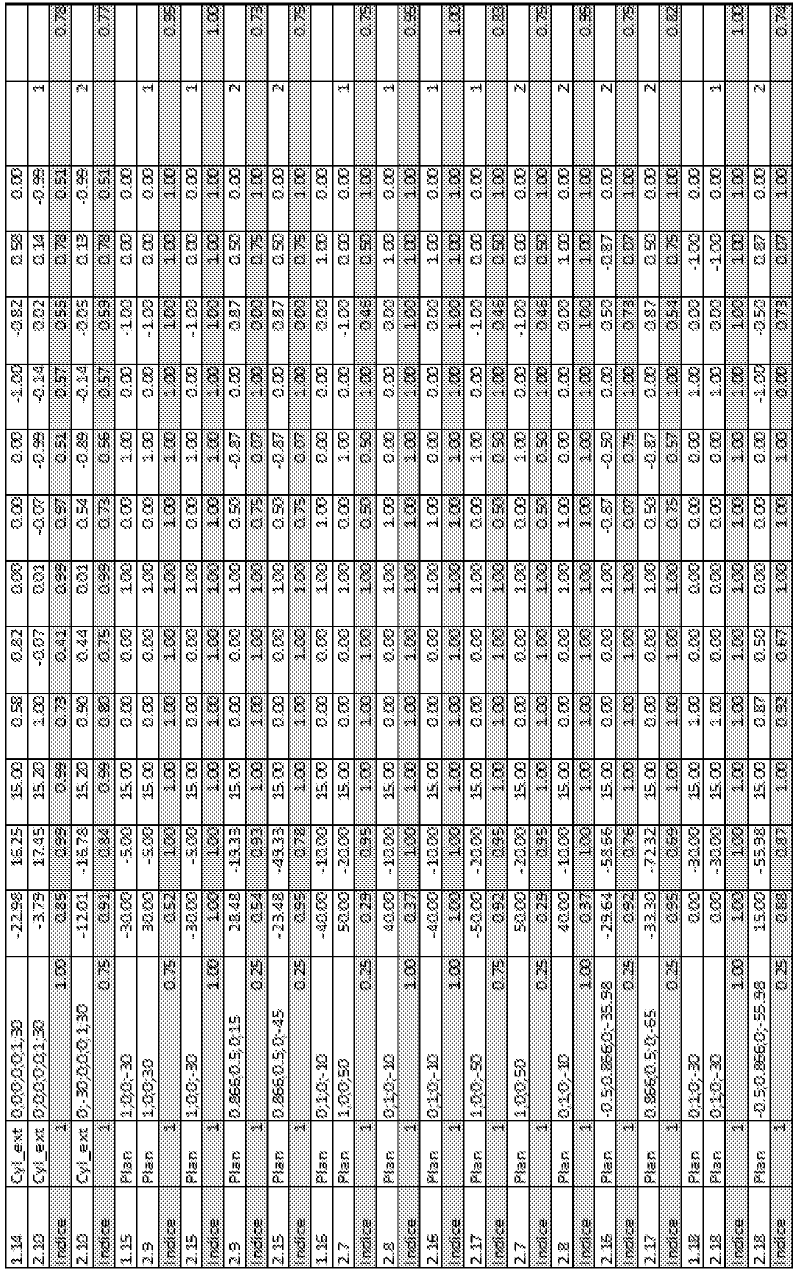

## Revendications

1. Un procédé de comparaison de descripteurs, mise en œuvre par un système informatique résidant dans un ordinateur, entre un modèle 3D de référence et une pluralité de modèles 3D cibles pour permettre des recherches, des classements et des analyses comparatives de modèles 3D, chaque modèle 3D comportant une ou plusieurs faces et étant représentés par les frontières, le procédé comprenant:
a) associer à chacun des modèles 3D, au moins un descripteur comprenant des caractéristiques géométriques associées à au moins une face du modèle 3D correspondant, et charger les descripteurs dans une base de données électronique du système informatique, lesdites caractéristiques géométriques comprennent des caractéristiques géométriques qui sont invariables en fonction d'un repère de modélisation et des caractéristiques géométriques qui dépendent du repère, et au moins un descripteur qui comprend des caractéristiques géométriques liées à des regroupements de faces ayant une dérivée seconde continue, notée faces G2, tout le long d'une arête commune aux faces;
b) utiliser des moyens de traitement associés à la base de données électronique pour comparer au moins une partie des caractéristiques géométriques et identifier les ressemblances et les différences de caractéristiques entre le descripteur associé au modèle 3D de référence et les descripteurs d'au moins un des modèles 3D cibles, la comparaison étant effectuée au moins entre les descripteurs de faces G2;
c) pour chacune des caractéristiques géométriques, utiliser les moyens de traitement pour calculer un indice de confiance en fonction des ressemblances et des différences identifiées;
d) utiliser les moyens de traitement pour calculer une valeur de similarité entre le modèle 3D de référence et au moins un modèle 3D cible, en fonction des indices de confiance calculés sur les caractéristiques géométriques;
e) permettre des recherches, des classements et des analyses comparatives par le système informatique résidant dans l'ordinateur selon des valeurs de similarités et des critères exprimés par un opérateur, les critères étant des contraintes sur les descripteurs.

2. Le procédé selon la revendication 1, dans lequel les caractéristiques géométriques des modèles 3D ayant des faces planes comprennent la superficie et/ou le périmètre des faces planes des modèles 3D, et le centre de gravité et/ou les axes des moments d'inertie des faces planes.

3. Le procédé selon la revendication 1 ou 2, dans lequel l'étape de comparer au moins une partie des caractéristiques des descripteurs des modèles 3D, inclut l'application d'une matrice de transformation à au moins un modèle 3D, par exemple basée sur les barycentres et les axes d'inertie dans le cas d'un recalage d'un modèle 3D et au besoin par un second recalage en utilisant une ou plusieurs faces comme référence, et on compare au moins une partie des caractéristiques.

4. Le procédé selon la revendication 3, dans lequel on calcule une valeur de similarité entre les modèles 3D en combinant la comparaison des descripteurs et au besoin celle après l'application d'une transformation à au moins un des descripteurs d'un modèle 3D.

5. Le procédé selon l'une des revendications 1 à 4, dans lequel on compare le descripteur d'un modèle 3D aux descripteurs d'un grand nombre de modèles 3D, et comprenant l'étape d'utiliser une partie des caractéristiques du descripteur d'un grand nombre de modèles 3D afin de prioriser ou de limiter l'étape d'utiliser un trop grand nombre des caractéristiques du descripteur et/ou un trop grand nombre de modèles 3D.

6. Le procédé selon la revendication 1 comprenant l'étape de demander à un opérateur de sélectionner des caractéristiques d'un modèle 3D pour les fins de comparaison à d'autres modèles 3D, et l'étape de fournir un descripteur comprend la création d'un descripteur selon les caractéristiques du modèle 3D sélectionnés par l'opérateur.

7. Le procédé selon la revendication 6, dans lequel l'opérateur sélectionne au moins une face.

8. Le procédé selon la revendication 6 ou 7, dans lequel l'opérateur sélectionne au moins une relation entre des caractéristiques du modèle 3D.

9. Le procédé selon la revendication 6, 7 ou 8, dans lequel l'opérateur sélectionne une pondération signifiant une importance, de préférence accrue ou réduite, des caractéristiques du modèle 3D.

10. Le procédé selon l'une des revendications 1 à 9, dans lequel on sélectionne au moins deux parties correspondantes sur au moins deux modèles, on identifie les parties respectives similaires, on identifie les parties différentes et on affiche au moins un des modèles en identifiant les parties similaires et différentes.

11. Le procédé selon la revendication 1 comprenant l'étape de comparer le descripteur d'un modèle 3D aux descripteurs d'un grand nombre de modèles 3D, et après avoir présenté des résultats de recherche selon un premier descripteur de recherche, on modifie ce premier descripteur de recherche afin de faire une recherche plus ciblée et/ou on modifie la méthode de calcul de l'indice de similarité.

12. Le procédé selon l'une des revendications 1, 3, 4, 5 à 11, dans lequel les données de comparaison sont stockées afin de faciliter des comparaisons suivantes.

13. Le procédé selon l'une des revendications 1 à 12, dans lequel on compare le descripteur d'un modèle 3D aux descripteurs d'un grand nombre de modèles 3D, et on présente des résultats de recherche suivant un indice de similarité avec les différences ou similarités identifiées précédemment.

14. Procédé selon l'une des revendications précédentes, comprenant en outre l'affichage sur une unité d'affichage des résultats de comparaison de modèles 3D, sous la forme d'une vue d'un espace 3D comprenant les modèles 3D indiquant leur différences et/ou leur similarités et ordonnés au besoin suivant leur indice de similarité.

15. Le procédé selon la revendication 14, dans lequel au moins une partie des similarités ou différences identifiées dans la comparaison entre le modèle 3D de référence et la pluralité de modèles 3D est affichée.

16. Procédé selon l'une des revendications 1 à 15, dans lequel l'affichage utilise des faces marquées des modèles 3D par rapport au modèle 3D de référence, chaque marquage identifiant les similitudes et / ou les différences entre le modèle 3D référence et au moins un modèle 3D cible comparé.

17. Procédé selon la revendication 16, dans lequel on présente au moins une ressemblance et/ou différence de caractéristiques géométriques reliées à la face correspondante entre au moins deux modèles 3D.

18. Système de traitement de données configuré de manière à réaliser le procédé de comparaison des modèles 3D aux fins d'une recherche, d'un classement ou d'une analyse comparative de modèles 3D selon l'une quelconque des revendications précédentes.

19. Procédé de fabrication d'un produit comprenant au moins une pièce, le procédé comprenant:
- la sélection par un opérateur des caractéristiques d'un modèle 3D de référence correspondant à ladite pièce à fabriquer;
- la comparaison, mise en œuvre par un système informatique résidant dans un ordinateur, du modèle 3D de référence avec une pluralité de modèles 3D cibles en réalisant le procédé de comparaison selon l'une quelconque des revendications 1 à 17 ;
- l'affichage d'un classement ou d'une analyse comparative du modèle 3D de référence avec plusieurs modèles 3D cibles en fonction des ressemblances et des différences identifiées;
- la sélection par l'opérateur d'un modèle 3D cible en fonction des ressemblances et des différences identifiées; et
- la fabrication de la pièce à partir du modèle 3D cible sélectionné.

## Patentansprüche

1. Ein Verfahren zum Vergleichen von Deskriptoren, das von einem in einem Computer befindlichen Computersystem ausgeführt wird, zwischen einem Referenz-3D-Modell und einer Mehrzahl von Ziel-3D-Modellen, um Suchen, Einstufungen und vergleichende Analysen von 3D-Modellen zu ermöglichen, wobei jedes 3D-Modell eine oder mehrere Flächen aufweist und durch Grenzen dargestellt ist, wobei das Verfahren Folgendes umfasst:
a) jedem 3D-Modell mindestens einen Deskriptor zuordnen, der geometrische Merkmale umfasst, die mindestens einer Fläche des entsprechenden 3D-Modells zugeordnet sind, und die Deskriptoren in eine elektronische Datenbank des Computersystems laden, wobei die geometrischen Merkmale geometrische Merkmale umfassen, die in Bezug auf ein Modellierungsbezugssystem invariant sind, und geometrische Merkmale, die von dem Bezugssystem abhängen, und wobei mindestens ein Deskriptor geometrische Merkmale umfasst, die mit Gruppierungen von Flächen mit einer stetigen zweiten Ableitung, bezeichnet als G2-Flächen, entlang einer gemeinsamen Kante der Flächen zusammenhängen;
b) Verarbeitungseinrichtungen, die mit der elektronischen Datenbank verbunden sind, verwenden, um mindestens einen Teil der geometrischen Merkmale zu vergleichen und Ähnlichkeiten und Unterschiede von Merkmalen zwischen dem Deskriptor, der dem Referenz-3D-Modell zugeordnet ist, und den Deskriptoren von mindestens einem der Ziel-3D-Modelle zu identifizieren, wobei der Vergleich zumindest zwischen den Deskriptoren der G2-Flächen durchgeführt wird;
c) für jedes geometrische Merkmal die Verarbeitungseinrichtungen verwenden, um einen Vertrauensindex in Abhängigkeit von den identifizierten Ähnlichkeiten und Unterschieden zu berechnen;
d) die Verarbeitungseinrichtungen verwenden, um einen Ähnlichkeitswert zwischen dem Referenz-3D-Modell und mindestens einem Ziel-3D-Modell in Abhängigkeit von den für die geometrischen Merkmale berechneten Vertrauensindizes zu berechnen;
e) Suchen, Einstufungen und vergleichende Analysen durch das in dem Computer befindliche Computersystem gemäß Ähnlichkeitswerten und von einem Bediener ausgedrückten Kriterien zu ermöglichen, wobei die Kriterien Einschränkungen bezüglich der Deskriptoren sind.

2. Verfahren nach Anspruch 1, bei dem die geometrischen Merkmale der 3D-Modelle mit ebenen Flächen die Fläche und/oder den Umfang der ebenen Flächen der 3D-Modelle sowie den Schwerpunkt und/oder die Achsen der Trägheitsmomente der ebenen Flächen umfassen.

3. Verfahren nach Anspruch 1 oder 2, bei dem der Schritt des Vergleichens von mindestens einem Teil der Merkmale der Deskriptoren der 3D-Modelle die Anwendung einer Matrix von Transformation auf mindestens ein 3D-Modell, beispielsweise basierend auf den Schwerpunkten und den Trägheitsachsen im Fall einer Registrierung eines 3D-Modells und gegebenenfalls durch eine zweite Registrierung unter Verwendung einer oder mehrerer Flächen als Referenz, und mindestens ein Teil der Merkmale wird verglichen.

4. Verfahren nach Anspruch 3, bei dem ein Ähnlichkeitswert zwischen den 3D-Modellen berechnet wird, indem der Vergleich der Deskriptoren und gegebenenfalls der Vergleich nach der Anwendung einer Transformation auf mindestens einen der Deskriptoren eines 3D-Modells kombiniert wird.

5. Verfahren nach einem der Ansprüche 1 bis 4, bei dem der Deskriptor eines 3D-Modells mit den Deskriptoren einer großen Anzahl von 3D-Modellen verglichen wird und wobei der Schritt umfasst, einen Teil der Merkmale des Deskriptors einer großen Anzahl von 3D-Modellen zu verwenden, um den Schritt der Verwendung einer zu großen Anzahl von Merkmalen des Deskriptors und/oder einer zu großen Anzahl von 3D-Modellen zu priorisieren oder zu beschränken.

6. Verfahren nach Anspruch 1, umfassend den Schritt, einen Bediener aufzufordern, Merkmale eines 3D-Modells zum Zweck des Vergleichs mit anderen 3D-Modellen auszuwählen, wobei der Schritt der Bereitstellung eines Deskriptors die Erstellung eines Deskriptors entsprechend den vom Bediener ausgewählten Merkmalen des 3D-Modells umfasst.

7. Verfahren nach Anspruch 6, bei dem der Bediener mindestens eine Fläche auswählt.

8. Verfahren nach Anspruch 6 oder 7, bei dem der Bediener mindestens eine Beziehung zwischen Merkmalen des 3D-Modells auswählt.

9. Verfahren nach Anspruch 6, 7 oder 8, bei dem der Bediener eine Gewichtung auswählt, die eine Bedeutung, vorzugsweise erhöhte oder verringerte Bedeutung, der Merkmale des 3D-Modells angibt.

10. Verfahren nach einem der Ansprüche 1 bis 9, bei dem mindestens zwei entsprechende Teile an mindestens zwei Modellen ausgewählt werden, die jeweiligen ähnlichen Teile identifiziert werden, die unterschiedlichen Teile identifiziert werden und mindestens eines der Modelle angezeigt wird, wobei die ähnlichen und unterschiedlichen Teile gekennzeichnet werden.

11. Verfahren nach Anspruch 1, umfassend den Schritt, den Deskriptor eines 3D-Modells mit den Deskriptoren einer großen Anzahl von 3D-Modellen zu vergleichen, und nachdem Suchergebnisse gemäß einem ersten Suchdeskriptor präsentiert wurden, wird dieser erste Suchdeskriptor geändert, um eine gezieltere Suche durchzuführen und/oder die Methode zur Berechnung des Ähnlichkeitsindex wird geändert.

12. Verfahren nach einem der Ansprüche 1, 3, 4, 5 bis 11, bei dem die Vergleichsdaten gespeichert werden, um spätere Vergleiche zu erleichtern.

13. Verfahren nach einem der Ansprüche 1 bis 12, bei dem der Deskriptor eines 3D-Modells mit den Deskriptoren einer großen Anzahl von 3D-Modellen verglichen wird und Suchergebnisse gemäß einem Ähnlichkeitsindex mit den zuvor identifizierten Unterschieden oder Ähnlichkeiten präsentiert werden.

14. Verfahren nach einem der vorhergehenden Ansprüche, ferner umfassend das Anzeigen auf einer Anzeigeeinheit der Ergebnisse des Vergleichs von 3D-Modellen in Form einer Ansicht eines 3D-Raums, der die 3D-Modelle umfasst, wobei deren Unterschiede und/oder deren Ähnlichkeiten angezeigt und gegebenenfalls entsprechend ihrem Ähnlichkeitsindex geordnet werden.

15. Verfahren nach Anspruch 14, bei dem mindestens ein Teil der bei dem Vergleich zwischen dem Referenz-3D-Modell und der Mehrzahl von 3D-Modellen identifizierten Ähnlichkeiten oder Unterschiede angezeigt wird.

16. Verfahren nach einem der Ansprüche 1 bis 15, bei dem die Anzeige markierte Flächen der 3D-Modelle im Verhältnis zu dem Referenz-3D-Modell verwendet, wobei jede Markierung die Ähnlichkeiten und/oder Unterschiede zwischen dem Referenz-3D-Modell und mindestens einem verglichenen Ziel-3D-Modell kennzeichnet.

17. Verfahren nach Anspruch 16, bei dem mindestens eine Ähnlichkeit und/oder ein Unterschied geometrischer Merkmale, die mit der entsprechenden Fläche zwischen mindestens zwei 3D-Modellen verknüpft sind, dargestellt wird.

18. Datenverarbeitungssystem, das derart konfiguriert ist, dass es das Verfahren zum Vergleich von 3D-Modellen zum Zweck einer Suche, einer Einstufung oder einer vergleichenden Analyse von 3D-Modellen nach einem der vorhergehenden Ansprüche durchführt.

19. Verfahren zur Herstellung eines Produkts, das mindestens ein Teil umfasst, wobei das Verfahren Folgendes umfasst:
- die Auswahl durch einen Bediener von Merkmalen eines Referenz-3D-Modells, das dem herzustellenden Teil entspricht;
- den Vergleich, ausgeführt durch ein in einem Computer befindliches Computersystem, des Referenz-3D-Modells mit einer Mehrzahl von Ziel-3D-Modellen durch Ausführen des Vergleichsverfahrens nach einem der Ansprüche 1 bis 17;
- die Anzeige einer Einstufung oder einer vergleichenden Analyse des Referenz-3D-Modells mit mehreren Ziel-3D-Modellen in Abhängigkeit von den identifizierten Ähnlichkeiten und Unterschieden;
- die Auswahl durch den Bediener eines Ziel-3D-Modells in Abhängigkeit von den identifizierten Ähnlichkeiten und Unterschieden; und
- die Herstellung des Teils anhand des ausgewählten Ziel-3D-Modells.

## Claims

1. A method for comparing descriptors, implemented by a computer system residing in a computer, between a reference 3D model and a plurality of target 3D models, in order to enable searching, ranking and comparative analysis of 3D models, each 3D model comprising one or more faces and being represented by boundaries, the method comprising:
a) associating with each 3D model at least one descriptor comprising geometric characteristics associated with at least one face of the corresponding 3D model, and loading the descriptors into an electronic database of the computer system, said geometric characteristics comprising geometric characteristics that are invariant with respect to a modelling reference frame and geometric characteristics that depend on the reference frame, and at least one descriptor comprising geometric characteristics related to groupings of faces having a continuous second derivative, denoted G2 faces, along an edge common to the faces;
b) using processing means associated with the electronic database to compare at least part of the geometric characteristics and to identify similarities and differences between characteristics of the descriptor associated with the reference 3D model and the descriptors of at least one of the target 3D models, the comparison being carried out at least between the descriptors of the G2 faces;
c) for each of the geometric characteristics, using the processing means to calculate a confidence index as a function of the identified similarities and differences;
d) using the processing means to calculate a similarity value between the reference 3D model and at least one target 3D model as a function of the confidence indexes calculated for the geometric characteristics; and
e) enabling, by the computer system residing in the computer, searches, rankings and comparative analyses as a function of the similarity values and of criteria expressed by an operator, the criteria being constraints on the descriptors.

2. The method according to claim 1, wherein the geometric characteristics of 3D models having planar faces comprise the area and/or the perimeter of the planar faces of the 3D models, and the center of gravity and/or the axes of the moments of inertia of the planar faces.

3. The method according to claim 1 or 2, wherein the step of comparing at least part of the characteristics of the descriptors of the 3D models comprises applying a transformation matrix to at least one 3D model, for example based on the barycentres and axes of inertia in the case of registration of a 3D model and, where necessary, by a second registration using one or more faces as a reference, and comparing at least part of said characteristics.

4. The method according to claim 3, wherein the similarity value between the 3D models is calculated by combining the comparison of the descriptors and, where necessary, the comparison after applying a transformation to at least one of the descriptors of a 3D model.

5. The method according to any one of claims 1 to 4, wherein the descriptor of a 3D model is compared with the descriptors of a large number of 3D models, and comprising the step of using a subset of the characteristics of the descriptor for a large number of 3D models in order to prioritise or limit the step of using too many characteristics of the descriptor and/or too many 3D models.

6. The method according to claim 1, comprising the step of prompting an operator to select characteristics of a 3D model for the purpose of comparison with other 3D models, and wherein the step of providing a descriptor comprises creating a descriptor according to the characteristics of the 3D model selected by the operator.

7. The method according to claim 6, wherein the operator selects at least one face.

8. The method according to claim 6 or 7, wherein the operator selects at least one relationship between characteristics of the 3D model.

9. The method according to any one of claims 6 to 8, wherein the operator selects a weighting indicating an importance of the characteristics of the 3D model, the importance preferably being increased or reduced.

10. The method according to any one of claims 1 to 9, wherein at least two corresponding parts are selected on at least two models, the respective similar parts are identified, the different parts are identified, and at least one of the models is displayed with indications of the similar parts and the different parts.

11. The method according to claim 1, comprising the step of comparing the descriptor of a 3D model with the descriptors of a large number of 3D models, and, after presenting search results according to a first search descriptor, modifying said first search descriptor in order to carry out a more targeted search and/or modifying a method of calculating the similarity index.

12. The method according to any one of claims 1, 3, 4 and 5 to 11, wherein comparison data are stored in order to facilitate subsequent comparisons.

13. The method according to any one of claims 1 to 12, wherein the descriptor of a 3D model is compared with the descriptors of a large number of 3D models, and search results are presented according to a similarity index together with the previously identified differences or similarities.

14. The method according to any one of the preceding claims, further comprising displaying, on a display unit, results of the comparison of 3D models in the form of a view of a 3D space comprising the 3D models and indicating their differences and/or similarities and, where appropriate, ordered according to their similarity index.

15. The method according to claim 14, wherein at least a portion of the similarities or differences identified in the comparison between the reference 3D model and the plurality of 3D models is displayed.

16. The method according to any one of claims 1 to 15, wherein the display uses marked faces of the 3D models relative to the reference 3D model, each marking identifying similarities and/or differences between the reference 3D model and at least one compared target 3D model.

17. The method according to claim 16, wherein at least one similarity and/or difference in geometric characteristics related to the corresponding face between at least two 3D models is presented.

18. A data processing system configured to carry out the method for comparing 3D models for the purpose of searching, ranking or comparative analysis of 3D models according to any one of the preceding claims.

19. A method of manufacturing a product comprising at least one part, the method comprising:
- selecting, by an operator, characteristics of a reference 3D model corresponding to said part to be manufactured;
- comparing, by a computer system residing in a computer, the reference 3D model with a plurality of target 3D models by carrying out the comparison method according to any one of claims 1 to 17;
- displaying a ranking or a comparative analysis of the reference 3D model with several target 3D models as a function of the identified similarities and differences;
- selecting, by the operator, a target 3D model as a function of the identified similarities and differences; and
- manufacturing the part from the selected target 3D model.
